(19) Europäisches Patentamt / European Patent Office / Office européen des brevets

(11) **EP 4 337 607 B1**

(12) **EUROPÄISCHE PATENTSCHRIFT**

(45) Veröffentlichungstag und Bekanntmachung des Hinweises auf die Patenterteilung:
**09.10.2024 Patentblatt 2024/41**

(21) Anmeldenummer: **22843253.0**

(22) Anmeldetag: **20.12.2022**

(51) Internationale Patentklassifikation (IPC):
**C01B 33/021** $^{(2006.01)}$     **C23C 16/24** $^{(2006.01)}$
**C23C 16/44** $^{(2006.01)}$     **H01M 4/134** $^{(2010.01)}$
**C23C 16/04** $^{(2006.01)}$     **C01B 33/029** $^{(2006.01)}$
**H01M 4/36** $^{(2006.01)}$     **H01M 4/38** $^{(2006.01)}$

(52) Gemeinsame Patentklassifikation (CPC):
**C23C 16/045; C01B 33/029; C23C 16/24; C23C 16/4417; H01M 4/134; H01M 4/366; H01M 4/386; Y02E 60/10**

(86) Internationale Anmeldenummer:
**PCT/EP2022/087133**

(87) Internationale Veröffentlichungsnummer:
**WO 2023/118239 (29.06.2023 Gazette 2023/26)**

(54) **VERFAHREN ZUR HERSTELLUNG EINES SILICIUM-KOMPOSITS**

PROCESS FOR PRODUCING A SILICON COMPOSITE

PROCÉDÉ DE PRODUCTION D'UN COMPOSITE DE SILICIUM

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **20.12.2021 PCT/EP2021/086900**

(43) Veröffentlichungstag der Anmeldung:
**20.03.2024 Patentblatt 2024/12**

(73) Patentinhaber: **Wacker Chemie AG**
**81671 München (DE)**

(72) Erfinder:
• **KALYAKINA, Alena**
**81737 München (DE)**
• **DRÄGER, Christoph**
**81737 München (DE)**
• **TILLMANN, Jan**
**81737 München (DE)**

(74) Vertreter: **Belz, Ferdinand et al**
**Wacker Chemie AG**
**Gisela-Stein-Straße 1**
**81671 München (DE)**

(56) Entgegenhaltungen:
**CN-A- 105 185 970     GB-B- 2 580 110**
**US-B1- 10 964 940**

**Beschreibung**

Die Erfindung betrifft ein Verfahren zur Herstellung eines Silicium-Komposits durch thermische Zersetzung von zumindest einem Si-Präkursor in Anwesenheit von porösen Partikeln, wobei Silicium in Poren und auf der Oberfläche der porösen Partikel abgeschieden wird und das Silicium-Komposit einen Soll-Gehalt an Silicium von 35 bis 60 Gew.-% aufweist.

Als Speichermedien für elektrischen Strom sind Lithium-Ionen-Batterien (LIB) gegenwärtig die praxistauglichsten elektrochemischen Energiespeicher mit den höchsten Energiedichten. LIB werden vor allem im Bereich der tragbaren Elektronik, für Werkzeuge und auch für elektrisch angetriebene Transportmittel, wie Fahrräder, Roller oder Automobile, genutzt. Als Aktivmaterial für negative Elektroden (Anode) ist graphitischer Kohlenstoff weit verbreitet. Nachteilig ist die relativ niedrige elektrochemische Kapazität solcher Kohlenstoffe, die theoretisch höchstens 372 mAh pro Gramm Graphit beträgt und nur etwa einem Zehntel der mit Lithiummetall theoretisch erreichbaren elektrochemischen Kapazität entspricht. Alternative Aktivmaterialien für die Anode verwenden einen Zusatz von Silicium, wie beispielsweise in der EP 1730800 B1 oder der EP 3335262 B1 beschrieben. Silicium bildet mit Lithium binäre elektrochemisch aktive Legierungen, die sehr hohe elektrochemisch erreichbare Lithiumgehalte von bis zu 3579 mAh pro Gramm Silicium ermöglichen.

Die Ein- und Auslagerung von Li-Ionen in Silicium geht mit dem Nachteil einher, dass dabei eine sehr starke Volumenänderung eintritt, die bei vollständiger Einlagerung bis zu 300 % betragen kann. Diese Volumenänderungen setzen das Si-enthaltende Aktivmaterial einer starken mechanischen Belastung aus, aufgrund derer das Aktivmaterial auseinanderbrechen kann. Dieser als elektrochemische Mahlung bezeichnete Prozess führt im Aktivmaterial und in der Elektrodenstruktur zu einem Verlust der elektrischen Kontaktierung und damit zum irreversiblen Verlust der Kapazität der Elektrode.

Weiterhin kann die Oberfläche des Si-enthaltenden Aktivmaterials mit Bestandteilen des Elektrolyten unter Bildung passivierender Schutzschichten (Solid Electrolyte Interphase; SEI) reagieren. Die gebildeten Komponenten sind nicht mehr elektrochemisch aktiv. Das darin gebundene Lithium steht dem System nicht mehr zur Verfügung, was zu einem ausgeprägten Kapazitätsverlust der LIB führt. Aufgrund der Volumenänderung des Siliciums während des Lade- bzw. Entladevorgangs der LIB bricht die SEI regelmäßig auf, wodurch weitere, noch nicht belegte Oberflächen des Si-enthaltenden Aktivmaterials freigelegt werden, die dann einer weiteren SEI-Bildung ausgesetzt sind. Da in einer LIB die Menge an mobilem Lithium, das der nutzbaren Kapazität entspricht, durch das Kathodenmaterial begrenzt ist, wird dieses zunehmend verbraucht und die Kapazität sinkt bereits nach wenigen Zyklen.

Als Aktivmaterialien für Anoden von LIB sind Si-C-Kompositpartikel bekannt, in denen Silicium ausgehend von gasförmigen oder flüssigen Präkursoren in poröse C-Partikel eingelagert wird. Der Vorteil von Si-C-Kompositen besteht darin, dass das Silicium fein verteilt in einem KohlenstoffGerüst eingebettet ist, welche die Volumenänderungen des Siliciums toleriert und gleichzeitig die elektrische Kontaktierung des Siliciums aufrechterhält. Solche Si-C-Komposite werden beispielsweise durch Gasphasenabscheidung von einem oder mehreren Si-Präkursoren in Poren von porösen Kohlenstoff-Matrizes hergestellt. Die Einbringung von Silicium in porösen Strukturen wird auch chemische Gasphaseninfiltration (CVI - *chemical vapor infiltration*) genannt.

Werden Si-Komposite über CVI hergestellt, so wird der Si-Präkursor zumeist bei geringem Absolut- und Partialdruck und damit in geringer Konzentration eingesetzt, was lange Reaktionszeiten zum Erreichen hoher Si-Anteile im Silicium enthaltenden Material erforderlich macht, da es sonst zur Ausbildung von dicken Si-Schichten, die auch grobes Silicium genannt werden, auf der Partikelaußenseite kommt. Diese dicken Si-Schichten sind insofern schädlich, als dass sie im Kontakt mit Elektrolyt und im Laufe der Zyklisierung zu einer starken Strukturierung der Partikeloberfläche in Kombination mit einer ständigen Neubildung der SEI führen. Zudem erfordert die optimale Einstellung der Prozessparameter eine genaue Kenntnis aller Reaktionsparameter, welche meist empirisch ermittelt werden müssen. Außerdem zeigen die eingesetzten porösen Matrizes eine gewisse Schwankungsbreite im Hinblick auf ihre Poren- und Partikelgrößenverteilung, so dass die Vermeidung einer Überinfiltration, welche zu dicken Si-Schichten führt, sehr herausfordernd ist. Weiterhin kommt es zur Bildung dicker Si-Schichten, wenn aus Gründen der Produktivität die Infiltration durchgehend bei höherer Konzentration des Silicium-Präkursors (Si-Präkursor) und/oder höherer Temperatur stattfindet.

Aus WO 2022/029422 A1 ist ein mittels CVI hergestelltes Si-C-Komposit bekannt, dass 25 bis 65 Gew.-% Silicium umfasst. Der Komposit besteht aus einem meso- und mikroporösen C-Gerüst, das eine Vielzahl an Domänen nanoskaligen, elementaren Siliciums innerhalb der Poren und auf seiner Oberfläche umfasst. Die Herstellung kann in einem Wirbelschichtreaktor bei einer Temperatur von 450°C und reduziertem Druck aus den porösen C-Partikeln und Silan erfolgen. Um die Bildung von dicken Si-Schichten (coarse bulk silicon) zu verhindern, wurde durchgehend mit Silankonzentrationen von weniger als 20 Vol.-% gearbeitet. Diese hohe Verdünnung führt zwangsläufig zu langen Reaktionszeiten und einem hohen Verbrauch an Inertgas und senkt somit die Wirtschaftlichkeit des Prozesses.

GB2580110B, US10964940B1 sowie CN105185970A beschreiben Verfahren zur Herstellung von Silicium-Komposite durch Infiltration von elementarem Silicium in poröse Kohlenstoffpartikel.

Die Aufgabe der Erfindung bestand vor diesem Hintergrund darin, ein Verfahren für die Herstellung eines Silicium enthaltenden Materials bereitzustellen, das bei seiner Verwendung als Aktivmaterial in Anoden von LIB eine hohe Zyklenfestigkeit gewährleistet, jedoch schneller und damit wirtschaftlicher zugänglich ist als dies bekannte Herstellungsverfahren ermöglichen. Dabei sollte die Bildung von dicken Siliciumschichten vermieden werden.

Gegenstand der Erfindung ist ein Verfahren zur Herstellung eines Silicium-Komposits durch thermische Zersetzung von zumindest einem Si-Präkursor in Anwesenheit von porösen Partikeln, wobei Silicium in Poren und auf der Oberfläche der porösen Partikel abgeschieden wird und das Silicium-Komposit einen Soll-Gehalt an Si von 35 bis 60 Gew.-% aufweist, wobei das Verfahren im Regelbetrieb durchgeführt wird bei

- einer mittleren Temperatur T von 300 bis 500°C und
- einer Konzentration C des Si-Präkursors von 30 bis 100 Vol.-% im zugeführten Gasstrom.

Das Verfahren umfasst mindestens einen Abschnitt A, in dem bei zumindest einem der Parameter T und C gegenüber dem Regelbetrieb und gegebenenfalls gegenüber einem weiteren Abschnitt A eine Änderung $\Delta$ erfolgt, wobei

$$\Delta T = 10 \text{ bis } 130°C$$

und

$$\Delta C = 2 \text{ bis } 70 \text{ Vol.-\%}$$

ist,

mit der Maßgabe, dass während des Abschnitts A 0,1 bis 50 % des genannten Soll-Gehalts an Silicium abgeschieden werden oder dass während zwei oder mehreren Abschnitten A insgesamt maximal 50 % des genannten Soll-Gehalts abgeschieden werden.

Ferner ist Gegenstand der Erfindung ein im Wesentlichen dem zuvor beschriebenen Verfahren entsprechendes, weiteres Verfahren, wobei das weitere Verfahren im Regelbetrieb durchgeführt wird bei

- einer mittleren Temperatur T von 300 bis 500°C,
- einer Konzentration C des Si-Präkursors von 30 bis 100 Vol.-% und
- einem Volumenstrom VS des Si-Präkursors von 0,01 bis 20 NL/h, bezogen auf 1 g der porösen Partikel.

Das weitere Verfahren umfasst ebenfalls mindestens einen Abschnitt A, in dem bei zumindest einem der Parameter T, C und VS gegenüber dem Regelbetrieb und gegebenenfalls gegenüber einem weiteren Abschnitt A eine Änderung $\Delta$ erfolgt, wobei

$$\Delta T = 10 \text{ bis } 130°C,$$

$$\Delta C = 2 \text{ bis } 70 \text{ Vol.-\%}$$

und

$$\Delta VS = 0,01 \text{ bis } 10 \text{ NL/h}$$

ist,

mit der Maßgabe, dass während des Abschnitts A 0,1 bis 50 % des genannten Soll-Gehalts an Silicium abgeschieden werden oder dass während zwei oder mehreren Abschnitten A insgesamt maximal 50 % des genannten Soll-Gehalts abgeschieden werden.

Ein Vorteil der erfindungsgemäßen Verfahren liegt darin, dass der Umsatz des Si-Präkursors während der gesamten Verfahrensdauer mehr als 30 % beträgt. Zudem erfolgt eine besonders gleichmäßige Abscheidung von Silicium auf und vor allem in den porösen Partikeln, was zu einer hohen Stabilität des resultierenden Silicium-Komposits in der Anwendung als Aktivmaterial in Anoden für LIB führt.

Die Aufteilung der Infiltrationsreaktion in Phasen mit unterschiedlichen Prozessparametern erlaubt eine gezielte Verkürzung der Gesamtprozesslaufzeit bei gleichzeitig hoher Produktperformanz. Überraschend wurde gefunden, dass der Umsatz des zugeführten Si-Präkursors bei statischen Bedingungen nicht konstant bleibt, sondern sich im Lauf der Reaktionsdauer verändert und es somit bei statischen Fahrweisen zu keiner optimalen Nutzung der Si-Präkursoren kommt. Dies wird durch die angepasste Fahrweise der Abscheidungsreaktion kompensiert, sodass der Umsatz steigt.

Zudem wird die nachteilige Bildung von dicken Si-Schichten durch das erfindungsgemäße Verfahren überraschenderweise überwunden, sodass die nach dem Verfahren erhaltenen Si-Komposite eine hohe elektrochemische Performanz aufweisen.

Der zugeführte Volumenstrom VS des Si-Präkursors in den Reaktor kann im Regelbetrieb 0,01 bis 10 NL/h, bevorzugt 0,01 bis 5 NL/h pro Gramm der eingesetzten porösen Partikel, betragen. Die Bestimmung des Volumenstroms kann über gängige Methoden, wie über ein Rotameter erfolgen.

$\Delta VS$ kann 0,01 bis 5 NL/h, bevorzugt 0,01 bis 2 NL/h pro Gramm der eingesetzten porösen Partikel, betragen.

Das Silicium-Komposit kann einen Soll-Gehalt an (über die Abscheidung aus dem Si-Präkursor erhaltenen) Silicium von 40 bis 55 Gew.-%, bevorzugt von 42 bis 50 Gew.-%, aufweisen, bezogen auf das Gesamtgewicht des Silicium-Komposits.

Der Soll-Gehalt an Si kann während des Verfahrens empirisch über wiederholte Probenentnahme bestimmt werden.

Bevorzugt wird der Soll-Gehalt an Si während des Verfahrens durch Analyse der Zusammensetzung eines Abgasstroms mit mindestens einer Methode ermittelt, ausgewählt aus der Gruppe mit Gaschromatographie, Massenspektrometrie, Infrarotspektroskopie und Wärmeleitfähigkeitsmessung.

Die Bestimmung des Soll-Gehalts an Si erfolgt besonders bevorzugt durch kontinuierliche Analyse der Abgaszusammensetzung mittels Gaschromatographie oder Wärmeleitfähigkeitsmessung. Der Abgasstrom kann dabei direkt am Reaktorausgang für die Analyse der Gaszusammensetzung entnommen werden. Die Bestimmung des abgeschiedenen Siliciums kann auch indirekt über die Quantifizierung des im Abgas enthaltenen Wasserstoffs erfolgen, sofern kein Wasserstoff zur Silanverdünnung verwendet wurde.

Die mittlere Temperatur T kann im Regelbetrieb 315°C bis 475°C, bevorzugt 330 bis 450°C, betragen.

Die mittlere Temperatur im Regelbetrieb $T_R$ ist als Mittelwert aller Temperaturen im Regelbetrieb definiert. Unter Temperatur wird die Temperatur in einem Prozess verstanden, über welche der Prozess gesteuert wird. Falls die Temperatur im Abschnitt A um $\Delta T$ geändert wird, ohne die Zufuhr des Si-Präkursors zu unterbrechen, wird eine Aufheizphase oder eine Abkühlphase als Teil des Abschnittes A betrachtet. Es wird dann die mittlere Temperatur des Abschnitts A ($T_A$) herangezogen.

$\Delta T$ kann 20 bis 100°C, bevorzugt 20 bis 50°C, betragen.

Die Konzentration C kann im Regelbetrieb 30 bis 100 Vol.-%, bevorzugt 50 bis 100 Vol.-%, betragen.

Die Werte für C beziehen sich vorzugsweise auf die Konzentration des Si-Präkursors im Reaktionsgas, also für gewöhnlich auf seine Konzentration in einer Zuführung des Reaktionsgases in einen Reaktor. Das Reaktionsgas umfasst üblicherweise den Si-Präkursor und/oder ein Inertgas wie Stickstoff. Die Konzentration des Si-Präkursors im zugeführten Reaktionsgas kann über geeignete Dosiereinrichtungen wie Rotameter eingestellt werden.

$\Delta C$ kann 5 bis 60 Vol.-%, bevorzugt 10 bis 50 Vol.-%, betragen.

Vorzugsweise erfolgt die Änderung $\Delta$ von zumindest einem der Parameter C, *T* und *VS* von Beginn des Abschnitts A bis zu dessen Ende kontinuierlich. In speziellen Ausführungsformen kann die Änderung auch stufenweise erfolgen.

In Abhängigkeit des ermittelten Soll-Gehalts an Si kann die Änderung $\Delta$ eingeleitet oder gestoppt werden. In anderen Worten kann abhängig von der Änderung $\Delta$ der Abschnitt A gestartet (Abweichung vom Regelbetrieb) oder beendet (Rückkehr zum Regelbetrieb) werden.

Vorzugsweise wird das Verfahren bei einem Druck von weniger als 0,7 MPa durchgeführt. Insbesondere bleibt der Druck während des Verfahrens im Wesentlichen konstant. *Im Wesentlichen* bedeutet dabei, dass der Druck eine Schwankungsbreite von ± 0,1 MPa aufweisen kann.

Die Herstellung der erfindungsgemäßen Si-Kompositpartikel kann in beliebigen, für die Si-Infiltration gängigen Reaktoren erfolgen. Bevorzugt sind Reaktoren ausgewählt aus Wirbelschichtreaktoren, Retortenöfen, Rohrreaktoren, Drehrohröfen, welche in beliebiger, von horizontaler bis hin zu vertikaler Anordnung ausgerichtet sein können, und Festbett-Reaktoren, welche als offene oder geschlossene Systeme, z.B. als Druckreaktoren, betrieben werden können. Besonders bevorzugt sind Reaktoren, welche eine homogene Durchmischung der porösen Partikel sowie des während der Infiltration entstehenden Silicium enthaltenden Materials (nur das fertige Endprodukt soll als Silicium-Komposit bezeichnet werden) mit den Si-Präkursoren ermöglichen. Dies ist vorteilhaft für eine möglichst homogene Abscheidung von Silicium in Poren und auf der Oberfläche der porösen Partikel. Am meisten bevorzugte Reaktoren sind Wirbelschichtreaktoren, Drehrohröfen, Druckreaktoren, Bett-Reaktoren.

Vorzugsweise wird das erfindungsgemäße Verfahren durchgeführt in einem Reaktor, der mit einem wandgängigen Rührer ausgestattet ist.

Ferner kann das Verfahren in einem Kaskadenreaktorsystem, umfassend mehrere Reaktoren, durchgeführt werden.

Die Durchführung im Kaskadenreaktorsystem kann gegenüber der Durchführung in nur einem Reaktor den Vorteil haben, dass lange Abkühl- und Aufheizphasen eines Reaktors reduziert werden. Daraus kann sich ein wirtschaftlicher Vorteil ergeben. Ein Kaskadenreaktorsystem kann außerdem den Vorteil bieten, dass die einzelnen Reaktoren genau auf ihren Zweck ausgelegt werden können. Ein Kaskadenreaktorsystem ist für gewöhnlich besser skalierbar, da unterschiedlich viele Reaktoren zu einzelnen Phasen miteinander kombiniert werden können. Die Anpassungen der Temperaturen, Volumenströme und Konzentrationen kann auch durch die Durchführung des Abschnitts A und dem Regelbetrieb in unterschiedlichen Reaktoren in der Reaktorkaskade erfolgen.

Das erfindungsgemäße Verfahren kann zumindest drei Phasen umfassen:

Phase 1: Befüllen eines Reaktors A mit porösen Partikeln und Vorbehandlung der Partikel mit anschließendem Transfer der vorbehandelten Partikel in einen Reaktor B

oder in einen Vorratsbehälter, oder das Material verbleibt im Reaktor A.

Phase 2: Durchströmung eines Reaktors B mit einem Gas, umfassend den Si-Präkursor und üblicherweise ein Inertgas. Ferner kann ein Si-freier Präkursor enthalten sein; Temperieren des Reaktors auf eine Temperatur, bei der die thermische Zersetzung des Si-Präkursors auf der Oberfläche und in den Poren der porösen Partikel stattfindet. Einstellen eines Verfahrensprofils, dass neben einem Regelbetrieb zumindest einen Abschnitt A umfasst, in welchem mindestens einer der Parameter T, C und VS geändert wird. Die Reaktion kann sowohl im Unter- als auch im Überdruck ablaufen. Nach der Einbringung des Siliciums in und auf die Poren der porösen Partikel wird das Si-Komposit in einen Reaktor C oder zur Zwischenlagerung in einen Vorratsbehälter überführt oder das Material verbleibt im Reaktor B.

Phase 3: Nachbehandlung des Si-Komposits zur Funktionalisierung und/oder Beschichtung der Oberfläche der Silicium-enthaltenden Partikel. Abkühlen der Partikel auf eine definierte Temperatur und Entnahme von Si-Komposit aus dem Reaktor C, und vorzugsweise direkte Überführung in einen Vorratsbehälter oder direkte Abfüllung in ein geeignetes Gebinde.

In Phase 1 werden poröse Partikel in einen beheizbaren und/oder vakuumfesten und/oder druckfesten Reaktor A gefüllt. Diese Befüllung kann manuell oder automatisch erfolgen.

Das Befüllen von Reaktor A mit porösen Partikeln kann unter Inertgasatmosphäre oder vorzugsweise Umgebungsluft durchgeführt werden. Als Inertgas können Wasserstoff, Helium, Neon, Argon, Krypton, Xenon, Stickstoff, Kohlendioxid oder Gemische hiervon, wie Formiergas, eingesetzt werden. Bevorzugt sind Argon oder Stickstoff.

Die automatische Befüllung kann mittels Dosierschnecke, Zellenrad, Rüttelrinne, Tellerdosierer, Banddosierer, Vakuumdosiersystem, Negativ-Verwiegung oder sonstigem Dosiersystem aus z.B. einem Silo oder sonstigem Containersystem erfolgen.

Ziel der Vorbehandlung der Partikel in Reaktor A in Phase 1 ist die Entfernung von Luft bzw. Sauerstoff, Wasser oder von Dispergiermitteln, wie Tenside oder Alkohole, und Verunreinigungen aus den Partikeln. Dies kann erreicht werden durch Inertisierung mit Inertgas (vgl. vorherigen Abschnitt), Erhöhung der Temperatur auf bis zu 1000°C, Reduktion des Drucks auf bis zu 1 Pa oder einer Kombination der einzelnen Prozessschritte.

Ziel der Vorbehandlung in Phase 1 kann außerdem die Veränderung der chemischen Oberflächenbeschaffenheit der porösen Partikel mit weiteren Substanzen sein. Die Zugabe kann vor oder nach der Trocknung erfolgen, und es kann ein weiterer Heizschritt erfolgen, bevor das Material in Reaktor B transferiert wird. Die Substanzen können gasförmig, fest, flüssig oder als Lösung in den Reaktor gegeben werden. Auch Mischungen, Emulsionen, Suspensionen, Aerosole oder Schäume sind möglich. Hierbei kann es sich um Kohlendioxid, Wasser, Natronlauge, Kalilauge, Flusssäure, Phosphorsäure, Salpetersäure, Salzsäure, Ammoniak, Ammoniumdihydrogenphosphat, Lithiumnitrat, Natriumnitrat, Kaliumnitrat, Lithiumchlorid, Natriumchlorid, Kaliumchlorid, Lithiumbromid, Natriumbromid, Kaliumbromid, Alkanolate handeln.

Der Transfer der porösen Partikel in einen weiteren Reaktor oder Behälter kann durch ein Fallrohr, Stetigförderer, Strömungsförderer/Saug- oder Druckförderanlage (z.B. Vakuumförderer, Transportgebläse); Mechanische Förderer (z.B. Rollenförderer mit Antrieb, Schneckenförderer, Kreisförderer, Umlaufförderer, Becherwerk, Zellenradschleusen, Kettenförderer, Kratzerförderer, Bandförderer, Schwingförderer); Schwerkraftförderer (z.B. Rutschen, Rollenbahn, Kugelbahn, Schienenbahn) erfolgen.

In Phase 2 wird das vorbehandelte Material in Reaktor B auf eine mittlere Temperatur von 300 bis 500°C gebracht, besonders bevorzugt 315 bis 475°C und insbesondere bevorzugt 330 bis 450°C.

Reaktor B kann während der Veränderung der Temperatur oder bei erreichter Temperatur oder beim Durchlaufen eines Temperaturprofils abwechselnd oder gleichzeitig mit einem Gas bestehend aus mindestens einem Inertgas und/oder mindestens einer Reaktivkomponente, bestehend aus mindestens einen Si-Präkursor und/oder mindestens einen Si-freien Präkursor durchströmt. Unterschiedliche Zusammensetzungen des Gases sind nacheinander möglich oder können während der Phase 2 im Rahmen der angegebenen Zusammensetzung variiert werden.

Als Si-freier Präkursoren (Präkursoren, die keinen Si-Präkursor enthalten) sind ein oder mehrere Kohlenwasserstoffe bevorzugt. Durch thermische Zersetzung der Kohlenwasserstoffe kann allgemein Kohlenstoff in Poren und auf der Oberfläche der porösen Partikel abgeschieden werden.

Die Si-freien Präkursoren enthalten vorzugsweise keine weitere Komponente oder ein oder mehrere Inertgase und/oder ein oder mehrere reaktive Bestandteile, wie Wasserstoff, und/oder ein oder mehrere Dotierstoffe. Dotierstoffe können sein Bor, Stickstoff, Phosphor, Arsen, Germanium, Eisen oder Nickel enthaltende Verbindungen. Die Dotierstoffe werden bevorzugt ausgewählt aus der Gruppe mit Ammoniak, Diboran, Phosphan, German, Arsan und Nickeltetracarbonyl.

Die Zudosierung des Reaktionsgases kann kontinuierlich oder stoßartig sein. Die Dosierrate kann während der Reaktionslaufzeit variieren.

Die Temperatur, der Druck, Druckänderungen oder Differenzdruckmessungen und Gasflussmessungen im Reaktor B können mit gängigen Messgeräten und Messmethoden bestimmt werden. Nach üblicher Kalibrierung ergeben unterschiedliche Messgeräte für gewöhnlich dieselben Messergebnisse.

Der Reaktor B kann mit einer solchen Menge an Si-Präkursoren über die Gesamtzeit der thermischen Zersetzung durchströmt werden, dass in Bezug auf die eingewogene Menge poröser Partikel eine für die Zielkapazität des herzustellenden Si-Komposits ausreichende Menge Silicium abgeschieden wird.

Das Aufheizen von Reaktor B in Phase 2 kann mit einer konstanten Heizrate oder mit mehreren unterschiedlichen Heizraten erfolgen. Heizraten können je nach Ausgestaltung des Verfahrens angepasst werden, z.B. je nach Größe des Reaktors, der Menge der porösen Partikel im Reaktor, der Rührtechnologie oder der geplanten Reaktionszeit.

Das Aufheizen von Reaktor B in Phase 2 kann mit Heizraten von 1 bis 100°C pro Minute, bevorzugt von 2 bis 50°C pro Minute, erfolgen.

Die Temperatur, bei der die Zersetzung des Si-Präkursors beginnt, kann von den eingesetzten porösen Partikeln, dem oder den eingesetzten Si-Präkursoren und den anderen Randbedingungen der Zersetzung, wie dem Partialdruck des Si-Präkursors zum Zeitpunkt der Zersetzung und der Anwesenheit von anderen Reaktivkomponenten, wie Katalysatoren, die die Zersetzungsreaktion beeinflussen, abhängen.

Während der Zersetzung der Si-Präkursoren in Phase 2 kann die Temperatur konstant gehalten oder auch variiert werden. Ziel ist der weitgehend vollständige Umsatz der Si-Präkursoren während der Kontaktzeit des Gases mit dem gerührten Bett unter Erzeugung eines für die Anwendung geeigneten Si-Komposits.

Die Zieltemperatur für $SiH_4$ kann bei 300 bis 500°C, bevorzugt bei 315 bis 475°C, besonders bevorzugt bei 330 bis 450°C, liegen. Die Zieltemperatur für $HSiCl_3$ kann bei 380 bis 1000°C, bevorzugt bei 420 bis 600°C, liegen. Die Zieltemperatur für $H_2SiCl_2$ kann bei 350 bis 800°C, bevorzugt bei 380 bis 500°C, liegen.

Neben Si-Präkursoren können in Phase 2 auch Si-freie Präkursoren wie C-Präkursoren eingesetzt werden. Dies kann als Mischung mit Si-Präkursoren, nacheinander oder alternierend erfolgen. Ziel ist gezielte Funktionalisierung der frisch gebildeten Silicium-Oberfläche.

Die Gasphase aus Phase 2 kann bestehen aus einem Inertgas und/oder mindestens einer Reaktivkomponente, enthaltend einen Si-Präkursor und/oder mindestens einen Si-freien Präkursor in möglicherweise variierender Zusammensetzung. Der eine oder die mehreren Si-Präkursoren können allgemein gemischt oder getrennt oder in Mischung mit Inertgasbestandteilen oder als Reinstoffe in Reaktor B eingebracht werden.

In Phase 2 wird die Schüttung, bestehend aus porösen Partikeln, vorzugsweise kontinuierlich umgewälzt. Die Umwälzung kann über ein oder mehrere Rührorgane oder über eine rotierende Bewegung des Reaktors selbst (z.B. Intensivmischer der Fa. Maschinenfabrik Gustav Eirich) oder Kombinationen daraus erfolgen. Der Bewegungszustand der bewegten Schüttung wird durch Froude-Zahlen zwischen 1 und 10 charakterisiert. Vorzugsweise liegt die Froude-Zahl zwischen 1 und 6, besonders bevorzugt zwischen 1 und 4.

Die thermische Zersetzung der Si-Präkursoren in Anwesenheit der porösen Partikel findet vorzugsweise bei 0,05 MPa bis 5 MPa, besonders bevorzugt bei 0,08 bis 0,7 MPa, statt.

Der Verlauf der Reaktion in Phase 2 wird bevorzugt analytisch verfolgt, um das Ende der Reaktion zu erkennen und so die Reaktorbelegungszeit möglichst gering zu halten. Verfahren zur Beobachtung des Reaktionsverlaufs umfassen dabei beispielsweise Temperaturmessung zum Feststellen einer Exo- oder Endothermie zur Feststellung des Reaktionsverlaufs durch sich ändernde Verhältnisse von festen zu gasförmigen Reaktorinhaltsbestandteilen sowie durch weitere Methoden, die die Beobachtung der sich verändernden Zusammensetzung des Gasraums während der Reaktion ermöglichen. In einer bevorzugten Variante des Verfahrens wird die Zusammensetzung der Gasphase durch einen Gaschromatographen und/oder Wärmeleitfähigkeitsdetektor und/oder ein Infrarotspektroskop und/oder ein Ramanspektroskop und/oder ein Massenspektrometer bestimmt. In einer bevorzugten Ausführungsform werden mittels eines Wärmeleitfähigkeitsdetektors der Wasserstoffgehalt und/oder ggf. vorhandene Chlorsilane mittels eines Gaschromatographen oder Gasinfrarotspektroskops bestimmt.

In einer weiteren bevorzugten Variante des Verfahrens ist der Reaktor B bzw. die Stelle des Gasaustrages mit einer technischen Möglichkeit ausgestattet, die zur Entfernung von auftretenden, kondensierbaren oder resublimierbaren Nebenprodukten dient. In einer besonders bevorzugten Variante wird hierbei Siliciumtetrachlorid kondensiert und separat vom Si-Komposit entfernt.

In Phase 3 des Verfahrens können die Si enthaltenden Partikel in Reaktor C nachbehandelt und/oder deaktiviert und/oder beschichtet werden. Vorzugsweise wird hierzu Reaktor C mit Sauerstoff, insbesondere mit einem Gemisch aus Inertgas und Sauerstoff, gespült. Dadurch kann die Oberfläche des Si-Komposits modifiziert und/oder funktionalisiert und/oder deaktiviert werden. Beispielsweise kann eine Reaktion etwaiger auf der Oberfläche des Si-Komposits vorhandener, reaktiver Gruppen erreicht werden. Bevorzugt wird dazu eine Mischung von Stickstoff, Sauerstoff und gegebenenfalls Alkohole und/oder Wasser eingesetzt, die bevorzugt höchstens 20 Vol.-%, besonders bevorzugt höchstens 10 Vol.-% und insbesondere bevorzugt höchstens 5 Vol.-% Sauerstoff sowie bevorzugt höchstens 100 Vol.-%, besonders bevorzugt höchstens 10 Vol.-% und insbesondere bevorzugt höchstens 1 Vol.-% Wasser enthält. Dieser Schritt erfolgt bevorzugt bei Temperaturen von höchstens 250°C, besonders bevorzugt bei höchstens 100°C und insbesondere bevorzugt bei höchstens 50°C. Die Deaktivierung der Partikeloberflächen kann auch mit einem Gasgemisch, enthaltend Inertgas und Alkohole, erfolgen. Bevorzugt werden hier Stickstoff und Isopropanol eingesetzt. Es können aber auch Methanol, Ethanol, Butanole, Pentanole oder langkettigere und verzweigte Alkohole und Diole eingesetzt werden.

Die Deaktivierung der Partikel kann auch durch Dispergierung in einem flüssigen Lösemittel oder ein Lösemittelgemisch erfolgen. Dieses kann Isopropanol oder eine wässrige Lösung enthalten. Wahlweise kann die Deaktivierung der Partikel in Phase 3 auch über eine Beschichtung mittels C-, Al-, B-haltiger Präkursoren bei Temperaturen von 200-800°C und optional anschließender Behandlung mit Sauerstoff-haltiger Atmosphäre erfolgen.

Als Aluminium-haltige Präkursoren können Trimethylaluminium ($(CH_3)_3Al$), Aluminium-2,2,6,6-tetramethyl-3,5-heptandionat ($Al(OCC(CH_3)_3CHCOC(CH_3)_3)_3$), Tris-(dimethylamido)-aluminium ($Al(N(CH_3)_2)_3$) und Aluminiumtriisopropanolat ($C_9H_{21}AlO_3$) eingesetzt werden.

Als Bor-haltige Präkursoren können Boran ($BH_3$), Triisopropylborat ($[(CH_3)_2CHO]_3B$), Triphenylboran ($(C_6H_5)_3B$) und Tris-(pentafluorophenyl)-boran $(C_6F_5)_3B$ eingesetzt werden.

In Phase 3 können auch Nachbeschichtungen der Partikel mit Festkörperelektrolyten über thermische Zersetzungen von beispielsweise Tert-Butyllithium und Trimethylphosphat eingeführt werden.

In Phase 3 können grundsätzlich die Si-Komposite, gegebenenfalls unter Erhalt einer in Reaktor C vorhandenen Inertgasatmosphäre, aus Reaktor C entnommen werden. Dies kann über folgende Austragsverfahren erfolgen: pneumatisch (mittels Über- oder Unterdruck); mechanisch (Zellenradschleuse, Telleraustrag, Austragsschnecke bzw. Rührorgan im Reaktor, Bandaustrag), gravimetrisch (Doppelklappe bzw. -kugelhahn ggf. unterstützt durch Vibration).

Beim Einsatz von Kohlenwasserstoffen in der Phase 3 und/oder zusätzlich zur Si-Infiltration während der Phase 2 als weitere Si-freie Präkursoren werden Zieltemperaturen angewendet, bei denen die Zersetzung der Kohlenwasserstoffe beginnt und Kohlenstoff in Poren und auf der Oberfläche der porösen Partikel abgeschieden wird. Vorzugsweise werden die Zieltemperaturen in dieser Ausführungsform im Bereich von 250 bis 1000°C, besonders bevorzugt von 350 bis 850°C und am meisten bevorzugt von 400 bis 650°C gewählt.

Technische Anforderungen an die Reaktoren und optionale Besonderheiten für spezielle Varianten der Erfindung:

Reaktor A:

- Der Reaktor ist mindestens temperierbar.
- Der Reaktor kann vakuumfest sein.
- System zur Vorheizung, Trocknung und Inertisierung der porösen Partikel.
- Es kann ein System zur gezielten Zugabe/Dosierung der porösen Partikel angeschlossen werden.
- Zum Trocknen bzw. Entfernen von Verunreinigungen der porösen Partikel kann ein System angeschlossen werden, das es erlaubt, kondensierbare oder resublimierbare Stoffe zu entfernen.
- Es kann ein System angeschlossen werden, mit dem die porösen Partikel in den Reaktor B überführt werden können

Reaktor B:

- Der Reaktor ist mindestens temperierbar.
- Enthält ein erfindungsgemäßes Rührwerk
- System zur Zudosierung von Reaktionsgas
- System zur Abführung von Reaktionsgas
- Zur Prozessvereinfachung kann ein Wasserstoffabscheider angeschlossen sein.
- Zur Entfernung von in den gasförmigen Reaktionsprodukten auftretenden, kondensierbaren oder resublimierbaren Nebenprodukten kann ein Behälter angeschlossen werden, der es erlaubt, die Nebenprodukte durch Kondensation oder Resublimation zu entfernen.
- Es kann ein System angeschlossen werden, mit dem das Material in den Reaktor C oder einen Vorratsbehälter überführt werden kann.

Reaktor C:

- Der Reaktor ist mindestens temperierbar.
- System zur Entfernung von kondensierbaren oder resublimierbaren Nebenprodukten.
- Es kann ein Behälter angeschlossen werden, der es erlaubt, die Nebenprodukte durch Kondensation oder Resublimation zu entfernen.
- System zur Zudosierung von Reaktionsgas zur Funktionalisierung
- System zur Abführung von Reaktionsgas
- Es kann ein System angeschlossen werden, mit dem das Material in einen Vorratsbehälter überführt werden kann.

Ein Reaktor kann zugleich temperierbar, druckfest und vakuumfest sein, alle Kombinationen sind möglich. Ein Reaktor kann aber auch jeweils nur eines der zuvor genannten Merkmale erfüllen.

Ein temperierbarer Reaktor ist allgemein ein Reaktor, der so betrieben werden kann, dass die Temperatur im Inneren im Bereich zwischen -40 und 1000°C eingestellt werden kann. Kleinere Temperaturbereiche sind möglich.

Vorzugsweise sind Reaktor A, B und C das gleiche Gefäß, oder anders ausgedrückt kann das Verfahren auch in nur einem Reaktor ablaufen. Es ist grundsätzlich nicht ausgeschlossen, dass Reaktor A, B und C dasselbe Gefäß sind.

Es kann vorgesehen sein, dass das Verfahren im Regelbetrieb und der zumindest eine Abschnitt A in einem Reaktor ausgeführt werden. Gemäß einer speziellen Ausführungsform können der Regelbetrieb und der Abschnitt A in getrennten Reaktoren ausgeführt werden.

Die porösen Partikel sowie das entstehende Si-Komposit können während des Prozesses allgemein als unbewegte Schüttung oder unter Durchmischung bewegt vorliegen. Eine bewegte Durchmischung der porösen Partikel bzw. des entstehenden Si-Komposits in Reaktor A, B und C ist bevorzugt. Während der thermischen Zersetzung des Si-Präkursors in Phase 2 müssen die Partikel jedoch generell durchmischt werden. Dadurch kann ein homogener Kontakt aller porösen Partikel mit dem Reaktionsgas oder eine homogene Temperaturverteilung der Schüttung erreicht werden. Die Umwälzung der Partikel kann durch Rühreinbauten im Reaktor oder die Bewegung des gesamten Reaktors um einen Rührer herbeigeführt werden.

Eine weitere bevorzugte Bauform der Reaktoren A, B und C sind feststehende Reaktoren mit sich bewegenden Rührorganen zur Umwälzung. Aufgabe der Umwälzung ist es, den porösen Feststoff möglichst gleichmäßig mit dem Reaktionsgas in Kontakt zu bringen. Bevorzugte Geometrien hierfür sind zylindrische Reaktoren, konische Reaktoren, kugelförmige, polyedrische, rotationssymmetrische Reaktoren oder Kombinationen davon. Die Bewegung des Rührorgans ist bevorzugt eine Rotationsbewegung. Für vertikal betriebene Reaktoren A, B und C sind Bauformen bevorzugt, bei denen beispielsweise über eine Hauptrührwelle ein Rührorgan oder mehrere Rührorgane durch eine Rotationsbewegung das Schüttgut durchmischen. Eine weitere Bauform für einen vertikal betriebenen Reaktor A, B oder C ist durch die Nutzung einer Förderschnecke gekennzeichnet. Für horizontal betriebene Reaktoren A, B oder C sind Bauformen bevorzugt, bei denen beispielsweise über eine Hauptrührwelle ein Rührorgan oder mehrere Rührorgane durch eine Rotationsbewegung das Schüttgut durchmischen. Für vertikal betriebene Reaktoren A, B oder C sind Rührorgane bevorzugt, ausgewählt aus der Gruppe enthaltend Wendelrührer, Spiralrührer, Ankerrührer oder allgemein Rührorgane, die das Schüttgut axial oder radial oder sowohl axial als auch radial fördern. Die Wandgängigkeit kann durch zusätzliche Abschaber am Rührorgan verringert werden. Neben den sich bewegenden Rührorganen sind für den Reaktor A, B oder C auch starre Einbauten, wie Leitbleche, möglich.

Für den Bau von Reaktor A, B oder C ist grundsätzlich jeder Werkstoff geeignet, der bei den jeweiligen Prozessbedingungen die notwendige mechanische Festigkeit und Beständigkeit aufweist. Bezüglich der chemischen Beständigkeit kann der Reaktor A, B oder C sowohl aus entsprechenden Vollmaterialien als auch aus chemisch nicht beständigen Materialien (drucktragend) mit speziellen Beschichtungen oder Plattierungen medienberührter Teile bestehen.

Kaskadenreaktorsystem ist die Verknüpfung von mindestens zwei Reaktoren. Die Anzahl von Reaktoren ist nach oben offen. Die Anzahl der Reaktoren A, B und C zueinander sowie deren Größen, Form, Material und Ausgestaltungen können unterschiedlich sein. Die Reaktoren können direkt miteinander verbunden sein oder örtlich voneinander getrennt sein, die Beschickung kann dann mittels beweglichen Vorratsbehältern erfolgen. Denkbar ist auch, dass mehrere Reaktoren B miteinander verschaltet werden und jeder Reaktionsschritt in einem separaten Reaktor B abläuft.

Si-Präkursoren und Si-freie Präkursoren sind bevorzugt gasförmig, flüssig, fest (z.B. sublimierbar), oder eine Stoffmischung gegebenenfalls bestehend aus Stoffen in verschiedenen Aggregatzuständen. In einer Variante des Verfahrens werden die Si-Präkursoren und direkt in die Schüttung aus porösen Partikeln im Reaktor gegeben, z.B. von unten oder von der Seite oder durch einen speziellen Rührer.

Der Si-Präkursor wird bevorzugt ausgewählt aus der Gruppe mit Silicium-Wasserstoff-Verbindungen wie Monosilan ($SiH_4$), Disilan ($Si_2H_6$) sowie höhere lineare, verzweigte oder auch zyklische Homologe, neo-Pentasilan ($Si_5H_{12}$), cyclo-Hexasilan ($Si_6H_{12}$), chlorhaltige Silane, wie Trichlorsilan ($HSiCl_3$), Dichlorsilan ($H_2SiCl_2$), Chlorsilan ($H_3SiCl$), Te-

trachlorsilan (SiCl$_4$), Hexachlordisilan (Si$_2$Cl$_6$) sowie höhere lineare, verzweigte oder auch cyclische Homologe wie 1,1,2,2-Tetrachlordisilan (Cl$_2$HSi-SiHCl$_2$), chlorierte und teilchlorierte Oligo- und Polysilane, Methylchlorsilane, wie Trichlormethylsilan (MeSiCl$_3$), Dichlordimethylsilan (Me$_2$SiCl$_2$) Chlortrimethylsilan (Me$_3$SiCl), Tetramethylsilan (Me$_4$Si), Dichlormethylsilan (MeHSiCl$_2$), Chlormethylsilan (MeH$_2$SiCl), Methylsilan (MeH$_3$Si), Chlordimethylsilan (Me$_2$HSiCl), Dimethylsilan (Me$_2$H$_2$Si), Trimethylsilan (Me$_3$SiH) und Mischungen aus den beschriebenen Siliciumverbindungen.

Insbesondere ist der Si-Präkursor ausgewählt aus der Gruppe mit Monosilan, Disilan, Trichlorsilan, Dichlorsilan, Methylsilan und Mischungen davon.

Weitere reaktive Bestandteile, die im Reaktionsgas enthalten sein können, umfassen Wasserstoff oder auch Kohlenwasserstoffe, ausgewählt aus der Gruppe mit aliphatische Kohlenwasserstoffe mit 1 bis 10 Kohlenstoffatomen, bevorzugt 1 bis 6 Kohlenstoffatomen, wie Methan, Ethan, Propan, Butan, Pentan, Isobutan, Hexan, Cyclopropan, Cyclobutan, Cyclopentan, Cyclohexan, Cycloheptan; ungesättigte Kohlenwasserstoffe mit 1 bis 10 Kohlenstoffatomen wie Ethen, Acetylen, Propen, Methylacetylen, Butylene, Butine (1-Butin, 2-Butin), Isopren, Butadien, Divinylbenzol, Vinylacetylen, Cyclohexadien, Cyclooctadien, zyklische ungesättigte Kohlenwasserstoffe, wie Cyclopropen, Cyclobuten, Cyclopenten, Cyclohexen, Cyclohexadien, Cyclopentadien, Dicyclopentadien oder Norbornadien, aromatische Kohlenwasserstoffe, wie Benzol, Toluol, p-,m-,o-Xylol, Styrol (Vinylbenzol), Ethylbenzol, Diphenylmethan oder Naphthalin, weitere aromatische Kohlenwasserstoffe, wie Phenol, o-, m-, p-Kresol, Cymol, Nitrobenzol, Chlorbenzol, Pyridin, Anthracen oder Phenanthren, Myrcen, Geraniol, Thioterpineol, Norbornan, Borneol, iso-Borneol, Bornan, Campher, Limonen, Terpinen, Pinen, Pinan, Caren, Phenol, Anilin, Anisol, Furan, Furfural, Furfurylalkohol, Hydroxymethylfurfural, Bishydroxymethylfuran und gemischte Fraktionen, die eine Vielzahl solcher Verbindungen enthalten, wie aus Erdgaskondensaten, Erdöldestillaten oder Koksofenkondensaten, gemischte Fraktionen aus den Produktströmen eines Fluid-Catalytic-Crackers (FCC), Steam-Crackers oder einer Fischer-Tropsch-Syntheseanlage, oder ganz allgemein kohlenwasserstoffhaltige Stoffströme aus der Holz-, Erdgas-, Erdöl- und Kohleverarbeitung.

Die porösen Partikel für das erfindungsgemäße Verfahren werden vorzugsweise ausgewählt aus der Gruppe mit amorphen Kohlenstoff in Form von Hardcarbon, Softcarbon, Mesocarbon, Microbeads, Naturgraphit oder synthetischem Graphit, ein- und mehrwandige Kohlenstoffnanoröhren und Graphen, Oxide wie Siliciumdioxid, Aluminiumoxid, Silicium-Aluminium-Mischoxide, Magnesiumoxid, Bleioxide und Zirkonoxid, Carbide wie Siliciumcarbide und Borcarbide, Nitride wie Siliciumnitride und Bornitride; und andere keramische Werkstoffe, wie sie sich durch folgende Komponentenformel beschreiben lassen:

Al$_a$B$_b$C$_c$Mg$_d$N$_e$O$_f$Si$_g$ mit $0 \leq a, b, c, d, e, f, g \leq 1$, mit mindestens zwei Koeffizienten a bis g > 0 und $a*3 + b*3 + c*4 + d*2 + g*4 \geq e*3 + f*2$.

Die keramischen Werkstoffe können z.B. binäre, ternäre, quaternäre, quinäre, senäre oder septernäre Verbindungen sein. Bevorzugt sind keramische Werkstoffe mit folgenden Komponentenformeln:

Nichtstöchiometrische Bornitride BN$_z$ mit z = 0,2 bis 1,

Nichtstöchiometrische Kohlenstoffnitride CN$_z$ mit z = 0,1 bis 4/3,

Borcarbonitride B$_x$CN$_z$ mit x = 0,1 bis 20 und z = 0,1 bis 20, wobei gilt $x*3 + 4 \geq z*3$,

Bornitridooxide BN$_z$O$_r$ mit z = 0,1 bis 1 und r = 0,1 bis 1, wobei gilt $3 \geq r*2 + z*3$,

Borcarbonitridooxide B$_x$CN$_z$O$_r$ mit x = 0,1 bis 2, z = 0,1 bis 1 und r = 0,1 bis 1, wobei gilt: $x*3 + 4 \geq r*2 + z*3$,

Siliciumcarbooxide Si$_x$CO$_z$ mit x = 0,1 bis 2 und z = 0,1 bis 2, wobei gilt $x*4 + 4 \geq z*2$,

Siliciumcarbonitride Si$_x$CN$_z$ mit x = 0,1 bis 3 und z = 0,1 bis 4, wobei gilt $x*4 + 4 \geq z*3$,

Siliciumborocarbonitride Si$_w$B$_x$CN$_z$ mit w = 0,1 bis 3, x = 0,1 bis 2 und z= 0,1 bis 4, wobei gilt $w*4 + x*3 + 4 \geq z*3$,

Siliciumborocarbooxide Si$_w$B$_x$CO$_z$ mit w = 0,10 bis 3, x = 0,1 bis 2 und z = 0,1 bis 4, wobei gilt $w*4 + x*3 + 4 \geq z*2$,

Siliciumborocarbonitridooxide Si$_v$B$_w$CN$_x$O$_z$ mit v = 0,1 bis 3, w = 0,1 bis 2, x = 0,1 bis 4 und z = 0,1 bis 3, wobei gilt $v*4 + w*3 + 4 \geq x*3 + z*2$ und

Aluminiumborosilicocarbonitridooxide Al$_u$B$_v$Si$_x$CN$_w$O$_z$ mit u = 0,1 bis 2, v = 0,1 bis 2, w = 0,1 bis 4, x = 0,1 bis 2 und z = 0,1 bis 3, wobei gilt $u*3 + v*3 + x*4 + 4 \geq w*3 + z*2$.

Bei den porösen Partikeln handelt es sich vorzugsweise um amorphen Kohlenstoff, ausgewählt aus der Gruppe mit Hardcarbon, Softcarbon, Mesocarbon, Microbeads, Naturgraphit oder synthetischem Graphit, ein- und mehrwandige Kohlenstoffnanoröhren, Graphen und Mischungen davon.

Bevorzugt besitzen die porösen Partikel eine durch Heliumpyknometrie bestimmte Dichte von 0,1 bis 7 g/cm³ und besonders bevorzugt von 0,3 bis 3 g/cm³. Dies ist vorteilhaft zur Steigerung der volumetrischen Kapazität (mAh/cm³) von LIB.

Die porösen Partikel weisen eine volumengewichtete Partikelgrößenverteilung mit Durchmesser-Perzentilen $d_{50}$ auf von vorzugsweise ≥ 0,5 μm, besonders bevorzugt ≥ 1,5 μm und am meisten bevorzugt ≥ 2 μm. Die Durchmesser-Perzentile $d_{50}$ sind vorzugsweise ≤ 20 μm, besonders bevorzugt ≤ 12 μm und am meisten bevorzugt ≤ 8 μm.

Die volumengewichtete Partikelgrößenverteilung der porösen Partikel liegt vorzugsweise zwischen den Durchmesser-Perzentilen $d_{10}$ ≥ 0,2 μm und $d_{90}$ ≤ 20,0 μm, besonders bevorzugt zwischen $d_{10}$ ≥ 0,4 μm und $d_{90}$ ≤ 15,0 μm und am meisten bevorzugt zwischen $d_{10}$ ≥ 0,6 μm bis $d_{90}$ ≤ 12,0 μm.

Die porösen Partikel haben eine volumengewichtete Partikelgrößenverteilung mit Durchmesser-Perzentilen $d_{10}$ von vorzugsweise ≤ 10 μm, besonders bevorzugt ≤ 5 μm, insbesondere bevorzugt ≤ 3 μm und am meisten bevorzugt ≤ 2 μm. Die Durchmesser-Perzentile $d_{10}$ sind vorzugsweise ≥ 0,2 μm, besonders bevorzugt ≤ 0,5 und am meisten bevorzugt ≥ 1 μm.

Die porösen Partikel haben eine volumengewichtete Partikelgrößenverteilung mit Durchmesser-Perzentilen $d_{90}$ von vorzugsweise ≥ 4 μm und besonders bevorzugt ≥ 8 μm. Die Durchmesser-Perzentile $d_{90}$ sind vorzugsweise ≤ 18 μm, besonders bevorzugt ≤ 15 und am meisten bevorzugt ≤ 13 μm.

Die volumengewichtete Partikelgrößenverteilung der porösen Partikel hat eine Breite $d_{90}$-$d_{10}$ von vorzugsweise ≤ 15,0 μm, mehr bevorzugt ≤ 12,0 μm, besonders bevorzugt ≤ 10,0 μm, insbesondere bevorzugt ≤ 8,0 μm und am meisten bevorzugt ≤ 4,0 μm.

Die volumengewichtete Partikelgrößenverteilung der nach dem erfindungsgemäßen Verfahren herstellbaren Si-Kompositen hat eine Breite $d_{90}$-$d_{10}$ von vorzugsweise ≥ 0,6 μm, besonders bevorzugt ≥ 0,8 μm und am meisten bevorzugt ≥ 1,0 μm.

Die volumengewichtete Partikelgrößenverteilung der porösen Partikel ist bestimmbar nach ISO 13320 mittels statischer Laserstreuung unter Anwendung des Mie-Modells mit dem Messgerät Horiba LA 950 mit Ethanol als Dispergiermedium für die porösen Partikel.

Die porösen Partikel liegen vorzugsweise in Form von vereinzelten Partikeln vor. Die Partikel können beispielsweise isoliert oder agglomeriert vorliegen. Die porösen Partikel sind vorzugsweise nicht aggregiert und vorzugsweise nicht agglomeriert. Aggregiert bedeutet allgemein, dass im Zuge der Herstellung der porösen Partikel zunächst Primärpartikel gebildet werden und zusammenwachsen und/oder Primärpartikel beispielsweise über kovalente Bindungen miteinander verknüpft sind und auf diese Weise Aggregate bilden. Primärpartikel sind allgemein isolierte Partikel. Aggregate oder isolierte Partikel können Agglomerate bilden. Agglomerate sind eine lose Zusammenballung von Aggregaten oder Primärpartikeln, die beispielsweise über Van-der-Waals-Wechselwirkungen oder Wasserstoffbrückenbindungen miteinander verknüpft sind. Agglomerierte Aggregate können nach gängigen Knet- und Dispergierverfahren leicht wieder in Aggregate aufgespalten werden. Aggregate lassen sich mit diesen Verfahren nicht oder nur teilweise in die Primärpartikel zerlegen. Das Vorliegen der porösen Partikel in Form von Aggregaten, Agglomeraten oder isolierten Partikeln kann beispielsweise mittels herkömmlicher Raster-Elektronen-Mikroskopie (REM) sichtbar gemacht werden. Statische Lichtstreuungsmethoden zur Bestimmung der Teilchengrößenverteilungen oder Partikeldurchmessern von Matrixpartikeln können dagegen nicht zwischen Aggregaten oder Agglomeraten unterscheiden.

Die porösen Partikel können eine beliebige Morphologie aufweisen, also beispielsweise splittrig, plattig, sphärisch oder auch nadelförmig sein, wobei splittrige oder sphärische Partikel bevorzugt sind. Die Morphologie kann beispielsweise durch die Sphärizität W oder die Sphärizität S charakterisiert werden. Gemäß der Definition von Wadell ist die Sphärizität W das Verhältnis aus der Oberfläche einer Kugel gleichen Volumens zur tatsächlichen Oberfläche eines Körpers. Im Falle einer Kugel hat W den Wert 1. Nach dieser Definition haben die porösen Partikel für das erfindungsgemäße Verfahren eine Sphärizität W von vorzugsweise 0,3 bis 1,0, besonders bevorzugt von 0,5 bis 1,0 und am meisten bevorzugt von 0,65 bis 1,0.

Die Sphärizität S ist das Verhältnis aus dem Umfang eines äquivalenten Kreises mit gleicher Fläche A wie die Projektion des auf eine Fläche projizierten Partikels und dem gemessenen Umfang U dieser Projektion: $S = 2\sqrt{\pi A}/U$. Im Falle eines ideal kreisförmigen Partikels hätte S den Wert 1. Für die porösen Partikel für das erfindungsgemäße Verfahren liegt die Sphärizität S im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität S erfolgt beispielsweise anhand von Aufnahmen einzelner Partikel mit einem optischen Mikroskop oder bei Partikeln < 10 μm bevorzugt mit einem Rasterelektronenmikroskop durch grafische Auswertung mittels einer Bildanalysesoftware, wie beispielsweise ImageJ.

Die porösen Partikel weisen bevorzugt ein gaszugängliches Porenvolumen von ≥ 0,2 cm³/g, besonders bevor-

zugt $\geq$ 0,6 cm$^3$/g und am meisten bevorzugt $\geq$ 1,0 cm$^3$/g auf. Dies ist förderlich, um LIB mit hoher Kapazität zu erhalten. Das gaszugängliche Porenvolumen wurde durch Gassorptionsmessungen mit Stickstoff gemäß DIN 66134 bestimmt.

Die porösen Partikel sind vorzugsweise offenporig. Offenporig bedeutet allgemein, dass Poren mit der Oberfläche von Partikeln verbunden sind, beispielsweise über Kanäle, und vorzugsweise mit der Umgebung in stofflichem Austausch, insbesondere in Austausch von gasförmigen Verbindungen, stehen können. Dies lässt sich anhand von Gassorptionsmessungen (Auswertung nach Brunauer, Emmett und Teller, "BET"), also der spezifischen Oberfläche nachweisen. Die porösen Partikel weisen spezifische Oberflächen von bevorzugt $\geq$ 50 m$^2$/g, besonders bevorzugt $\geq$ 500 m$^2$/g und am meisten bevorzugt $\geq$ 1000 m$^2$/g auf. Die BET-Oberfläche wird gemäß DIN 66131 (mit Stickstoff) bestimmt.

Die Poren der porösen Partikel können beliebige Durchmesser aufweisen, also allgemein im Bereich von Makroporen (oberhalb von 50 nm), Mesoporen (2 - 50 nm) und Mikroporen (kleiner 2 nm) liegen. Die porösen Partikel können in beliebigen Mischungen verschiedener Porentypen eingesetzt werden. Bevorzugt werden poröse Partikel mit weniger als 30% Makroporen, bezogen auf das Gesamtporenvolumen, besonders bevorzugt poröse Partikel ohne Makroporen und ganz besonders bevorzugt poröse Partikel mit zumindest 50% Poren mit einem mittleren Porendurchmesser unter 5 nm eingesetzt. Ganz besonders bevorzugt weisen die porösen Partikel ausschließlich Poren mit einem Porendurchmesser kleiner 2 nm auf (Bestimmungsmethode: Porengrößenverteilung nach BJH (Gasadsorption) gemäß DIN 66134 im Mesoporenbereich und nach Horvath-Kawazoe (Gasadsorption) gemäß DIN 66135 im Mikroporenbereich; die Bewertung der Porengrößenverteilung im Makroporen-Bereich erfolgt durch Quecksilberporosimetrie nach DIN ISO 15901-1).

Bevorzugt sind poröse Partikel mit gasunzugänglichem Porenvolumen von kleiner 0,3 cm$^3$/g und besonders bevorzugt kleiner 0,15 cm$^3$/g. Auch damit kann die Kapazität der LIB gesteigert werden. Das gasunzugängliche Porenvolumen kann mittels der folgenden Formel bestimmt werden:

Gasunzugängliches Porenvolumen = 1/Reinmaterialdichte - 1/Skelettdichte.

Dabei ist die Reinmaterialdichte eine theoretische Dichte der porösen Partikel, basierend auf der Phasenzusammensetzung oder der Dichte des Reinstoffes (Dichte des Materials als hätte es keine geschlossene Porosität). Daten zu Reinmaterialdichten lassen sich durch den Fachmann beispielsweise dem Ceramic Data Portal des National Institute of Standards entnehmen (NIST, https://srdata.nist.gov/CeramicDataPortal/scd). Beispielsweise beträgt die Reinmaterialdichte von Siliciumoxid 2,203 g/cm$^3$, die von Bornitrid beträgt 2,25 g cm$^3$, die von Siliciumnitrid beträgt 3,44 g/cm$^3$ und die von Siliciumcarbid beträgt 3,21 g/cm$^3$. Die Skelettdichte ist die tatsächliche, durch Heliumpyknometrie bestimmte Dichte der porösen Partikel (Gas-zugänglich).

Generell fungieren die porösen Partikel als Startmaterial zur Herstellung des Silicium-Komposits. Vorzugsweise befindet sich in den Poren der porösen Partikel und auf der Oberfläche der porösen Partikel vor Durchführung der erfindungsgemäßen Verfahren kein Silicium, also insbesondere kein Silicium, das durch Abscheiden von Si-Präkursoren erhalten wird.

Das mittels Abscheidung von Silicium in Poren und auf der Oberfläche der porösen Partikel nach dem erfindungsgemäßen Verfahren erhältliche Silicium-Komposit kann eine volumengewichtete Partikelgrößenverteilung mit Durchmesser-Perzentilen $d_{50}$ in einem Bereich aufweisen von 0,5 bis 20 $\mu$m. Bevorzugt beträgt der $d_{50}$-Wert zumindest 1,5 $\mu$m, und besonders bevorzugt zumindest 2 $\mu$m. Die Durchmesser-Perzentile $d_{50}$ betragen vorzugsweise höchstens 13 $\mu$m und besonders bevorzugt höchstens 8 $\mu$m.

Die volumengewichtete Partikelgrößenverteilung des Silicium-Komposits liegt vorzugsweise zwischen den Durchmesser-Perzentilen $d_{10} \geq 0,2$ $\mu$m und $d_{90} \leq 20,0$ $\mu$m, besonders bevorzugt zwischen $d_{10} \geq 0,4$ $\mu$m und $d_{90} \leq 15,0$ $\mu$m und insbesondere zwischen $d_{10} \geq 0,6$ $\mu$m bis $d_{90} \leq 12,0$ $\mu$m.

Das Silicium-Komposit hat eine volumengewichtete Partikelgrößenverteilung mit Durchmesser-Perzentilen $d_{10}$ von vorzugsweise $\leq 10$ $\mu$m, besonders bevorzugt $\leq 5$ $\mu$m, insbesondere bevorzugt $\leq 3$ $\mu$m und am meisten bevorzugt $\leq 1$ $\mu$m. Die Durchmesser-Perzentile $d_{10}$ sind vorzugsweise $\geq 0,2$ $\mu$m, besonders bevorzugt $\geq 0,4$ $\mu$m und insbesondere $\geq 0,6$ $\mu$m.

Das Silicium-Komposit hat eine volumengewichtete Partikelgrößenverteilung mit Durchmesser-Perzentilen $d_{90}$ von vorzugsweise $\geq 5$ $\mu$m und besonders bevorzugt $\geq 10$ $\mu$m. Die Durchmesser-Perzentile $d_{90}$ sind vorzugsweise $\leq 20$ $\mu$m, besonders bevorzugt $\leq 15$ um und insbesondere $\leq 12$ $\mu$m.

Die volumengewichtete Partikelgrößenverteilung des Silicium-Komposits kann eine Breite $d_{90}$-$d_{10}$ haben von $\leq 15,0$ $\mu$m, bevorzugt $\leq 12,0$ $\mu$m, besonders bevorzugt $\leq 10,0$ $\mu$m, insbesondere $\leq 8,0$ $\mu$m und insbesondere bevorzugt von $\leq 4,0$ $\mu$m. Die volumengewichtete Partikelgrößenverteilung des Silicium-Komposits hat eine Breite $d_{90}$-$d_{10}$ von vorzugsweise $\geq 0,6$ $\mu$m, besonders bevorzugt $\geq 0,8$ $\mu$m und insbesondere $\geq 1,0$ $\mu$m.

Die Partikel des Silicium-Komposits liegt vorzugsweise in Form von Partikeln vor. Die Partikel können isoliert oder agglomeriert vorliegen. Das Silicium-Komposit ist vorzugsweise nicht aggregiert und vorzugsweise nicht agglomeriert. Die Begriffe isoliert, agglomeriert und nicht aggregiert wurden in Bezug auf die porösen Partikel bereits definiert.

Das Vorliegen von Silicium-Komposit in Form von Aggregaten oder Agglomeraten kann beispielsweise mittels herkömmlicher Raster-Elektronen-Mikroskopie (REM) sichtbar gemacht werden.

Das Si-Komposit kann eine beliebige Morphologie aufweisen, also z.B. splittrig, plattig, sphärisch oder auch nadelförmig sein, wobei splittrige oder sphärische Partikel bevorzugt sind.

Gemäß der Definition von Wadell ist die Sphärizität W das Verhältnis aus der Oberfläche einer Kugel gleichen Volumens zur tatsächlichen Oberfläche eines Körpers. Im Falle einer Kugel hat W den Wert 1. Nach dieser Definition haben die nach dem erfindungsgemäßen Verfahren zugänglichen Si-Komposite eine Sphärizität W von vorzugsweise 0,3 bis 1,0 besonders bevorzugt von 0,5 bis 1,0 und am meisten bevorzugt von 0,65 bis 1,0.

Die Sphärizität S ist das Verhältnis aus dem Umfang eines äquivalenten Kreises mit gleicher Fläche A wie die Projektion des auf eine Fläche projizierten Partikels und dem gemessenen Umfang $U$ dieser Projektion: $S = 2\sqrt{\pi A}/U$ . Bei einem ideal kreisförmigen Partikel hätte S den Wert 1. Für den nach dem erfindungsgemäßen Verfahren zugänglichen Silicium-Komposit liegt die Sphärizität S im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität $S$ erfolgt z.B. anhand von Aufnahmen einzelner Partikel mit einem optischen Mikroskop oder bei Partikeln kleiner 10 $\mu$m bevorzugt mit einem Rasterelektronenmikroskop (REM) durch grafische Auswertung mittels einer Bildanalysesoftware, wie ImageJ.

Über die Morphologie, die materielle Zusammensetzung, insbesondere der spezifischen Oberfläche oder der inneren Porosität des Silicium-Komposits kann die Zyklisierungsstabilität von LIB weiter gesteigert werden.

Falls die porösen Partikel Si-Verbindungen enthalten, z.B. in Form von Siliciumdioxid, lassen sich die vorgenannten Angaben in Gew.-% für das über die Abscheidung aus dem Si-Präkursor erhaltene Silicium bestimmen, indem die mittels Elementaranalyse ermittelte Si-Masse der porösen Partikel von der mittels Elementaranalyse ermittelten Si-Masse des Silicium-Komposits subtrahiert wird und das Ergebnis durch die Masse des Silicium-Komposits dividiert wird.

Das Volumen des in porösen Partikeln abgeschiedenen Siliciums ergibt sich aus dem Massenanteil des über die Abscheidung aus dem Si-Präkursor erhaltenen Siliciums an der Gesamtmasse des Silicium-Komposits dividiert durch die Dichte von Silicium (2,336 g/cm$^3$) .

Das Porenvolumen $P$ des Silicium-Komposits ergibt sich aus der Summe von gaszugänglichem und gasunzugänglichem Porenvolumen. Das gaszugängliche Porenvolumen nach Gurvich des Silicium-Komposit ist bestimmbar durch Gassorptionsmessungen mit Stickstoff nach DIN 66134.

Das gasunzugängliche Porenvolumen des Silicium-Komposits ist bestimmbar nach: Gasunzugängliches Porenvolumen = 1/Skelettdichte - 1/Reinmaterialdichte, wie oben beschrieben.

Das Porenvolumen $P$ des Si-Komposits liegt bevorzugt im Bereich von 0 bis 400 Vol.-%, besonders bevorzugt im Bereich von 100 bis 350 Vol.-% und insbesondere bevorzugt im Bereich von 200 bis 350 Vol.-%, bezogen auf das Volumen des im Si-Komposit enthaltenen, aus der Abscheidung aus dem Si-Präkursor erhaltenen Siliciums.

Die im Silicium-Komposit enthaltene Porosität kann sowohl gaszugänglich als auch gasunzugänglich sein. Das Verhältnis des Volumens von gaszugänglicher zu gasunzugänglicher Porosität des Silicium-Komposits kann generell im Bereich von 0 (keine gaszugänglichen Poren) bis 1 (alle gaszugänglich) liegen. Bevorzugt liegt das Verhältnis des Volumens von gaszugänglicher zu gasunzugänglicher Porosität des Silicium-Komposits im Bereich von 0 bis 0,8, besonders bevorzugt im Bereich von 0 bis 0,3 und insbesondere bevorzugt von 0 bis 0,1.

Die Poren des Silicium-Komposits können beliebige Durchmesser aufweisen, beispielsweise im Bereich von Makroporen (> 50 nm), Mesoporen (2-50 nm) und Mikroporen (< 2 nm) liegen. Das Si-Komposit kann auch beliebige Mischungen verschiedener Porentypen enthalten. Bevorzugt enthält es höchstens 30% Makroporen, bezogen auf das Gesamtporenvolumen. Besonders bevorzugt ist ein Si-Komposit ohne Makroporen und ganz besonders bevorzugt ist ein Si-Komposit mit mindestens 50% Poren, bezogen auf das Gesamtporenvolumen mit einem mittleren Porendurchmesser unter 5 nm. Insbesondere bevorzugt weist das Si-Komposit ausschließlich Poren mit einem Durchmesser von höchstens 2 nm auf.

Das Si-Komposit weist Si-Strukturen auf, die in mindestens einer Dimension Strukturgrößen von bevorzugt höchstens 1000 nm, besonders bevorzugt kleiner 100 nm, insbesondere kleiner 5 nm (Bestimmungsmethode: REM und/oder High-Resolution-Transmissions-Electron-Microscopy (HR-TEM)) aufweisen.

Bevorzugt enthält das Sim-Komposit Si-Schichten mit einer Schichtdicke unterhalb von 1000 nm, besonders bevorzugt kleiner 100 nm, insbesondere kleiner 5 nm (Bestimmung: REM und/oder HR-TEM). Das Si-Komposit kann auch Silicium in Form von Partikeln enthalten. Si-Partikel haben einen Durchmesser von bevorzugt höchstens 1000 nm, besonders bevorzugt kleiner 100 nm, insbesondere kleiner 5 nm (Bestimmung: REM und/oder HR-TEM). Die Angabe zu den Si-Partikeln bezieht sich hierbei vorzugsweise auf den Durchmesser des Umkreises der Partikel im Mikroskopiebild.

Vorzugsweise beträgt die Menge an grobem Silicium am abgeschiedenen Silicium weniger als 3 Gew.%, besonders bevorzugt weniger als 1 Gew.%, insbesondere bevorzugt weniger als 0,1 Gew.%.

Das Si-Komposit hat bevorzugt eine spezifische Oberfläche von höchstens 100 m$^2$/g, besonders bevorzugt

kleiner 30 m$^2$/g, und insbesondere bevorzugt kleiner 10 m$^2$/g. Die BET-Oberfläche wird gemäß DIN 66131 (mit Stickstoff) bestimmt. Damit kann bei Einsatz des Si-Komposits als Aktivmaterial in Anoden für LIB die SEI-Bildung reduziert und die initiale Couloumb-Effizienz gesteigert werden.

Ferner kann das aus dem Si-Präkursor abgeschiedene Silicium im Si-Komposit Dotierstoffe enthalten, z.B. ausgewählt aus der Gruppe mit Li, Fe, Al, Cu, Ca, K, Na, S, Cl, Zr, Ti, Pt, Ni, Cr, Sn, Mg, Ag, Co, Zn, B, P, Sb, Pb, Ge, Bi, seltene Erden und Kombinationen daraus. Bevorzugt sind dabei Li und/oder Sn. Der Gehalt an Dotierstoffen im Si-Komposit beträgt bevorzugt höchstens 1 Gew.-% und besonders bevorzugt höchstens 100 ppm, bezogen auf das Gesamtgewicht des Si-Komposits, bestimmbar mittels ICP-OES.

Das Si-Komposit weist eine überraschend hohe Stabilität bei Druckbelastung und/oder Scherbelastung auf. Die Druckstabilität und die Scherstabilität zeigt sich dabei z.B. dadurch, dass das Si-Komposit bei Druck- (z.B. bei der Elektrodenverdichtung) bzw. Scherbelastung (z.B. bei der Elektrodenpräparation) keine oder nur geringfügige Änderungen ihrer porösen Struktur im REM aufweist.

Das Si-Komposit kann gegebenenfalls zusätzliche Elemente wie Kohlenstoff enthalten. Bevorzugt ist Kohlenstoff in Form von dünnen Schichten mit einer Schichtdicke von höchstens 1 $\mu$m, bevorzugt kleiner 100 nm, besonders bevorzugt kleiner 5 nm und ganz besonders bevorzugt kleiner 1 nm enthalten (Bestimmung: REM und HR-TEM). Die C-Schichten können dabei sowohl in den Poren als auch auf der Oberfläche des Si-Komposits vorhanden sein. Auch die Reihenfolge verschiedener Schichten im Si-Komposit durch entsprechende Wiederholungen der abwechselnden Dosierung unterschiedlicher Präkursoren sowie deren Anzahl ist beliebig. So kann auf den porösen Partikeln zunächst eine Schicht eines weiteren, von den porösen Partikeln unterschiedlichen Materials, wie Kohlenstoff, vorhanden sein und darauf eine Si-Schicht oder eine Schicht von SiPartikeln zugegen sein. Auch kann auf der Si-Schicht oder auf der Schicht von Si-Partikeln wiederum eine Schicht eines weiteren Materials vorhanden sein, welches vom Material der porösen Partikel verschieden oder gleich diesem sein kann, unabhängig davon, ob zwischen den porösen Partikeln und der Si-Schicht oder der aus Si-Partikeln bestehenden Schicht eine weitere Schicht eines von dem Material der porösen Partikel unterschiedlichen Materials vorhanden ist.

Das Si-Komposit kann ≤ 50 Gew.-%, bevorzugt ≤ 40 Gew.-%, besonders bevorzugt ≤ 20 Gew.-%, an zusätzlichen Elementen enthalten. Das Silicium-Komposit kann insbesondere ≥ 1 Gew.-%, insbesondere bevorzugt ≥ 2 Gew.-%, an zusätzlichen Elementen enthalten. Die Angaben in Gew.-% beziehen sich auf das Gesamtgewicht des Si-Komposits. Das Si-Komposit kann auch keine zusätzlichen Elemente enthalten.

Das nach dem erfindungsgemäßen Verfahren erhaltene Si-Komposit eignet sich als Aktivmaterial in Anodenmaterialien für Anoden von LIB sowie die Verwendung solcher Anoden zur Herstellung von LIB. Generell sind alle zur Herstellung erforderlichen Stoffe und Materialien bekannt. Die Herstellung der Komponenten derartiger Batterien und ihre Zusammenfügung erfolgt nach den auf dem Gebiet der Batterieherstellung bekannten Verfahren.

Das nach den erfindungsgemäßen Verfahren erhaltene Si-Komposit zeichnet sich durch ein deutlich verbessertes elektrochemisches Verhalten aus und führt zu LIB mit hohen volumetrischen Kapazitäten und hervorragenden Anwendungseigenschaften. Das Si-Komposit ist permeabel für Li-Ionen sowie Elektronen und ermöglicht somit den Ladungstransport. Die SEI in LIB kann mit dem erhaltenen Si-Komposit in großem Umfang reduziert werden. Zusätzlich löst sich die SEI auf Grund des Designs des Si-Komposits nicht mehr oder zumindest in weit geringerem Umfang von der Oberfläche des Aktivmaterials ab. All dies führt zu einer hohen Zyklenbeständigkeit von LIB, in deren Anoden das nach den erfindungsgemäßen Verfahren erhältliche Si-Komposit enthalten ist.

Die nachfolgenden Beispiele dienen zur weiteren Erläuterung der hier beschriebenen Erfindung.

Folgende analytische Methoden und Geräte wurden zur Charakterisierung eingesetzt:

Anorganische Analytik / Elementaranalyse:

Die in den Beispielen angegebenen Kohlenstoff-Gehalte wurden mit einem Leco CS 230 Analysator ermittelt, zur Bestimmung von O- und ggf. N- bzw. H-Gehalten wurde ein Leco TCH-600 Analysator eingesetzt. Die qualitative und quantitative Bestimmung von anderen angegebenen Elementen erfolgte mittels ICP-(inductively coupled plasma) Emissionspektrometrie (Optima 7300 DV, Fa. Perkin Elmer). Die Proben wurden dazu in einer Mikrowelle (Microwave 3000, Fa. Anton Paar) sauer aufgeschlossen (HF/HNO$_3$). Die ICP-OES-Bestimmung orientiert sich an der ISO 11885 "Wasserbeschaffenheit - Bestimmung von ausgewählten Elementen durch induktiv gekoppelte Plasma-Atom-Emissionsspektrometrie (ICP-OES) (ISO 11885:2007); Deutsche Fassung EN ISO 11885:2009", die zur Untersuchung saurer, wässriger Lösungen eingesetzt wird (z.B. angesäuerte Trinkwasser-, Abwasser- und andere Wasserproben, Königswasserextrakte von Böden und Sedimenten). Die Genauigkeit der verwendeten Si-Bestimmungsmethode beträgt in der Regel ±1 Gew.-%.

Partikelgrößenbestimmung:

Die Bestimmung der Partikelgrößenverteilung erfolgte nach ISO 13320 mittels statischer Laserstreuung mit einem Horiba LA 950. Dabei muss bei der Vorbereitung der Proben besondere Sorgfalt auf die Dispergierung der Partikel in der Messlösung aufgewendet werden, um statt der Größe von Einzelpartikeln nicht die Größe von Agglomeraten zu messen. Die Partikel wurden für die Messung in Ethanol dispergiert. Dazu wurde die Dispersion vor der Messung bei Bedarf 4 min in einem Hielscher Ultraschall-Laborgerät Modell UIS250v mit Sonotrode LS24d5 mit 250 W Ultraschall behandelt.

Oberflächenmessung nach BET:

Die spezifische Oberfläche der Materialien wurde über Gasadsorption mit Stickstoff mit einem Gerät Sorptomatic 199090 (Porotec) oder Gerät SA-9603MP (Horiba) nach der BET-Methode gemessen (Bestimmung nach DIN ISO 9277:2003-05 mit Stickstoff).

Skelettdichte:

Die Skelettdichte, d.h. die Dichte des porösen Festkörpers basierend auf dem Volumen ausschließlich der von außen gaszugänglichen Porenräume, wurde mittels He-Pyknometrie gemäß DIN 66137-2 bestimmt.

Gaszugängliches Porenvolumen:

Das gaszugängliche Porenvolumen nach Gurvich wurde durch Gassorptionsmessungen mit Stickstoff gemäß DIN 66134 bestimmt.

Thermogravimetrie (TGA) und Bestimmung von grobem Silicium:

Die Reaktivität der Pulver gegenüber Sauerstoff wurde mittels TGA-Messungen in reinem Sauerstoff in einem Temperaturfenster von 25-1000°C unter Verwendung einer Heizrate von 5 K/min bestimmt.

Umsatz:

Der Umsatz berechnet sich als Quotient aus der Stoffmenge in mol des umgesetzten, bezogen auf die Stoffmenge in mol des eingesetzten, Ausgangsstoffs (Edukt). Der Umsatz zeigt wie viele der eingesetzten $SiH_4$-Moleküle zu einem gewählten Zeitpunkt zu Si umgewandelt werden. Der Umsatz ist variabel und kann sich über die Prozesslaufzeit verändern.

$$Umsatz\ SiH_4\ in\ \% = \frac{Stoffmenge\ an\ gewonnenem\ Si}{Stoffmenge\ an\ eingesetztem\ SiH_4} * 100\%$$

Der Gesamtumsatz gibt an, wie viel Silicium über den gesamten Prozess in Relation zum eindosierten Silicium abgeschieden wurde.

Durchsatz:

Der Durchsatz beschreibt, wie viel Gew.-% Si in einer Stunde eingebracht werden. Er berechnet sich aus dem Si-Gehalt (Soll-Gehalt an Si) des entnommenen Produkts in Gew.-% im Verhältnis zur Abscheidedauer über alle Phasen in Stunden.

$$Durchsatz, in\ Gew. -\%/h = \frac{Gesamtmenge\ an\ abgeschiedenen\ Si\ in\ Gew. -\%}{Gesamtdauer\ der\ Dosierung\ von\ Si - Pr\ddot{a}kursor\ in\ h}$$

**Beispiele**

In den Beispielen sollte ein Si-Komposit mit einem Siliciumanteil von 47 bis 49 Gew.-% hergestellt werden.
Das eingesetzte $SiH_4$, der Qualität 4.0, wurde bei Linde GmbH erworben.
In allen Beispielen wurde der amorphe Kohlenstoff als poröses Ausgangsmaterial eingesetzt:

- spez. Oberfläche = 1636 $m^2$/g

- Porenvolumen = 0,76 cm$^2$/g
- mittlere volumengewichtete Partikelgröße D50 = 6,4 $\mu$m

Anteil des abgeschiedenen Siliciums am Soll-Gehalt:

Es sollen während des Abschnitts A 0,1 bis 50 % oder während zwei oder mehreren Abschnitten A insgesamt maximal 50 % des Soll-Gehalts abgeschieden werden.

Dieser Anteil des abgeschiedenen Si während eines Abschnitts A oder während des Regelbetriebs am Soll-Gehalt gibt an, zu welchem relativen Anteil Si in der entsprechenden Phase abgeschieden wird. Beispielsweise entsprechen 48 Gew.-% Soll-Gehalt an Si eines Komposits einem relativen Anteil an abgeschiedenen Si von 100%. 50% während des Abschnitts A abgeschiedenem Si entsprechen, dann einem Soll-Gehalt an Si von 24 Gew.-% im Komposit.

Die Ermittlung von feinem und grobem Silicium in einer Probe kann über die Reaktion von Silicium mit Sauerstoff unter Bildung von $SiO_2$ mittels TGA-Messungen durchgeführt werden. Die Unterscheidbarkeit verschiedener Si-Spezies kann dadurch begründet werden, dass dünne Siliciumschichten eine höhere Reaktivität gegenüber Sauerstoff aufzeigen, als dicke Schichten oder Si-Partikel. Dies hat zur Folge, dass dünne Si-Schichten in TGA-Messungen schon bei niedrigen Temperaturen (400-650°C) reagieren (Massenzunahme) und dicke Schichten bzw. grobe Si-Strukturen erst bei Temperaturen von mehr als 700°C eine Reaktion zeigen. Idealerweise zeigen Silicium enthaltende Komposite, welche als Anodenaktivmaterialien verwendet werden sollen, keine Massenzunahme in einer TGA-Messung unter sauerstoffhaltiger Atmosphäre bei Temperaturen von mehr als 800°C. Über diese Methode kann weiterhin der Gehalt an elementarem Silicium bestimmt werden. Zuvor durch Luftkontakt oxidiertes und passiviertes Silicium nimmt nicht mehr an der Reaktion teil und wird in den TGA-Messungen somit nicht berücksichtigt.

Zur Berechnung des enthaltenen groben Siliciums ist der Massenrückstand (mrück) der TGA-Methode nötig und die Massendifferenz (mdiff), welche sich durch die Oxidation des groben Siliciums ergibt. Mit der molaren Masse von $O_2$ (32 g/mol) und der molaren Masse von $SiO_2$ (60,08 g/mol) lässt sich nun über folgende Formel der Anteil des groben Siliciums am abgeschiedenen Silicium berechnen:

$$grobes\ Si, \% = mdiff * \frac{60,08\frac{g}{mol}}{32\frac{g}{mol} * mrück} * 100\%$$

**Vergleichsbeispiel 1:** Herstellung eines Si-Komposits in einem dafür geeigneten Reaktor.

Ein Rohrreaktor wurde mit 2,2 g der porösen Kohlenstoffpartikel (spez. Oberfläche = 1636 m$^2$/g; Gurvich-Porenvolumen = 0,76 cm$^3$/g, mittlere volumengewichtete Partikelgröße $D_{50}$ = 6,40 pm) in einem Quarzglasschiffchen beladen. Nach Inertisierung mit Stickstoff wurde der Reaktor auf 410°C erhitzt. Bei Erreichen dieser Temperatur wurde der Si-Präkursor (50% $SiH_4$ in $N_2$, 10 NL/h) in den Reaktor geleitet. Dabei wurde die Zersetzungsreaktion des $SiH_4$ zu Si über einen Wärmeleitfähigkeitsdetektor im Abgasstrom verfolgt und quantifiziert. Nachdem 2,1 g Si abgeschieden wurden, wurde der $SiH_4$ Gasstrom auf einen reinen Stickstoffstrom umgestellt und die Heizung ausgeschaltet. Der Reaktor wurde unter $N_2$-Spülung auf Raumtemperatur abgekühlt und das Produkt entnommen.

**Vergleichsbeispiel 2:** Herstellung eines Silicium-Komposits in einem dafür geeigneten Reaktor.

Ein Rohrreaktor wurde mit 2,2 g der porösen Kohlenstoffpartikel (spez. Oberfläche = 1636 m$^2$/g, Gurvich-Porenvolumen = 0,76 cm$^3$/g, mittlere volumengewichtete Partikelgröße $D_{50}$ = 6,40 pm) in einem Quarzglasschiffchen beladen. Nach Inertisierung mit Stickstoff wurde der Reaktor auf 380°C erhitzt. Bei Erreichen dieser Temperatur wurde der Si-Präkursor (50% $SiH_4$ in $N_2$, 10 NL/h) in den Reaktor geleitet. Dabei wurde die Zersetzungsreaktion des $SiH_4$ zu Si über einen Wärmeleitfähigkeitsdetektor im Abgasstrom verfolgt und quantifiziert. Nachdem 2,1 g Si abgeschieden wurden, wurde der $SiH_4$ Gasstrom auf einen reinen Stickstoffstrom umgestellt und die Heizung ausgeschaltet. Der Reaktor wurde unter $N_2$-Spülung auf Raumtemperatur abgekühlt und das Produkt entnommen.

**Beispiele 1-2:** Herstellung eines Si-Komposits nach dem erfindungsgemäßen Verfahren mit einem Abschnitt A (Der Index A weist auf die Parameter des Abschnitts A hin).

Ein Rohrreaktor wurde mit 2,2g der porösen Kohlenstoffpartikel (spez. Oberfläche = 1636 m$^2$/g, Gurvich-Porenvolumen = 0,76cm$^3$/g, mittlere volumengewichtete Partikelgröße $D_{50}$ = 6,40 pm) in einem Quarzglasschiffchen beladen. Nach Inertisierung mit Stickstoff wurde der Reaktor auf $T_A$ erhitzt (Abschnitt (Index) A). Bei Erreichen der Zieltemperatur wurde das Monosilan als Mischung mit $N_2$ (Konzentration $C_A$, Volumenstrom Si-Präkursor $VS_A$) in den Reaktor geleitet. Dabei wurde die Zersetzungsreaktion des $SiH_4$ zu Si über einen Wärmeleitfähigkeitsdetektor im Abgasstrom verfolgt und quantifiziert. Nachdem $M_A$ [g] Si abgeschieden wurden, wurde die Anlage in den Regelbetrieb (Index R) überführt: Temperatur $T_R$, Monosilan Konzentration $C_R$, Volumenstrom Si-Präkursor $VS_R$ und die weitere Si-Menge $M_R$ wurde im Regelbetrieb abgeschieden. Der Reaktor wurde anschließend unter $N_2$-Spülung auf Raumtemperatur abgekühlt und das Silicium-Komposit entnommen.

**Tabelle 1:** Versuchsparameter für die erfindungsgemäßen Beispiele 1 bis 2

| Versuchsparameter | Bezeichnung | Beispielnummer | |
|---|---|---|---|
| | | Bspl | Bsp2 |
| Si abgeschieden im Regelbetrieb, [g] | $M_R$ | 2,220 | 1,910 |
| Si abgeschieden im Abschnitt A, [g] | $M_A$ | 0, 006 | 0, 004 |
| Temperatur im Regelbetrieb, [°C] | $T_R$ | 410 | 400 |
| Temperatur im Abschnitt A, [°C] | TA | 380 | 400 |
| $SiH_4$ Konz im Regelbetrieb, [Vol. -% ] | $C_R$ | 50 | 50 |
| $SiH_4$ Konz im Abschnitt A, [Vol. -% ] | $C_A$ | 50 | 30 |
| Volumenstrom $SiH_4$ pro Gramm Kohlenstoff im Regelbetrieb [NL/h pro Gramm Kohlenstoff im Reaktor] | $VS_R$ | 2,27 | 2,27 |
| Volumenstrom $SiH_4$ pro Gramm Kohlenstoff im Abschnitt A [NL/h pro Gramm Kohlenstoff im Reaktor] | $VS_A$ | 2,27 | 1,36 |

**Beispiele 3-4:** Herstellung von Si-Komposit nach dem erfindungsgemäßen Verfahren mit mehreren Abschnitten A

Ein Rohrreaktor wurde mit 2,2g der porösen Kohlenstoffpartikel (spez. Oberfläche = 1636 $m^2$/g, Gurvich-Porenvolumen = 0,76$cm^3$/g, mittlere volumengewichtete Partikelgröße $D_{50}$ = 6,40 pm) in einem Quarzglasschiffchen beladen. Nach Inertisierung mit Stickstoff wurde der Reaktor auf $T_{A1}$ erhitzt (Abschnitt (Index) A1). Bei Erreichen der Zieltemperatur wurde das Monosilan als Mischung mit $N_2$ (Konzentration $C_{A1}$, Volumenstrom Si-Präkursor $VS_{A1}$) in den Reaktor geleitet. Dabei wurde die Zersetzungsreaktion des $SiH_4$ zu Si über einen Wärmeleitfähigkeitsdetektor im Abgasstrom verfolgt und quantifiziert. Nachdem $M_{A1}$ [g] Si abgeschieden wurde (Abschnitt (Index) A1), wurde die Anlage in den Regelbetrieb überführt: Temperatur $T_R$, Monosilan Konzentration $C_R$, Volumenstrom Si-Präkursor $VS_R$ und die weitere Si-Menge $M_R$ [g] wurde im Regelbetrieb abgeschieden. Nachdem $M_R$ [g] Silicium im Regelbetrieb abgeschieden wurde (Soll-Gehalt an Si bis zu diesem Moment $M_{A1}+M_R$), wurde die Anlage wieder umgestellt und eine erneute Änderung $\Delta$ vorgenommen (Abschnitt (Index) A2): Temperatur $T_{A2}$, Monosilan Konzentration $C_{A2}$, Volumenstrom Si-Präkursor $VS_{A2}$ und die weitere Si-Menge $M_{A2}$ [g] wurde abgeschieden. Der Reaktor wurde anschließend mit $N_2$ gespült und auf Raumtemperatur abgekühlt und das Produkt entnommen.

**Tabelle 2:** Versuchsparameter für die erfindungsgemäßen Beispiele 1 bis 2

| Versuchsparameter | Bezeichnung | Beispielnummer | |
|---|---|---|---|
| | | Bsp3 | Bsp4 |
| Si abgeschieden im Regelbetrieb, [g] | $M_R$ | 1,58 | 1,24 |
| Si abgeschieden im Abschnitt A1, [g] | $M_{A1}$ | 0,20 | 0,42 |
| Si abgeschieden im Abschnitt A2, [g] | $M_{A2}$ | 0,20 | 0,42 |
| Temperatur im Regelbetrieb, [°C] | $T_R$ | 410 | 400 |
| Temperatur im Abschnitt A1, [°C] | $T_{A1}$ | 380 | 400 |
| Temperatur im Abschnitt A2, [°C] | $T_{A2}$ | 380 | 400 |
| $SiH_4$ Konz im Regelbetrieb, [Vol.-%] | $C_R$ | 50 | 100 |
| $SiH_4$ Konz im Abschnitt A1, [Vol. -% ] | $C_{A1}$ | 50 | 50 |
| $SiH_4$ Konz im Abschnitt A2, [Vol. -% ] | $C_{A2}$ | 50 | 50 |
| Volumenstrom $SiH_4$ im Regelbetrieb, [NL/h pro Gramm Kohlenstoff im Reaktor] | $VS_R$ | 2,27 | 4,55 |
| Volumenstrom $SiH_4$ im Abschnitt A1, [NL/h pro Gramm Kohlenstoff im Reaktor] | $VS_{A1}$ | 2,27 | 2,27 |

(fortgesetzt)

| Versuchsparameter | Bezeichnung | Beispielnummer | |
|---|---|---|---|
| | | Bsp3 | Bsp4 |
| Volumenstrom SiH$_4$ im Abschnitt A2, [NL/h pro Gramm Kohlenstoff im Reaktor] | VS$_{A2}$ | 2,27 | 2,27 |

Die Reaktionsbedingungen zur Herstellung sowie die Materialeigenschaften des Si-Komposits sind in der folgenden Tabelle 3 zusammengefasst.

Tabelle 3

| | Vbsp 1* | Vbsp 2* | Bsp 1 | Bsp 2 | Bsp 3 | Bsp 4 |
|---|---|---|---|---|---|---|
| **Regelbetrieb:** Anteil am Sollgehalt im Produkt, [%Si] | 100 | 100 | 99, 72 | 99,8 | 80 | 60 |
| **Regelbetrieb:** Temperatur T$_R$, [°C] | 410 | 380 | 410 | 400 | 410 | 400 |
| **Regelbetrieb:** Monosilan Konz. C$_R$, [Vol. -%] | 50 | 50 | 50 | 50 | 50 | 100 |
| **Regelbetrieb:** Monosilan Volumenstrom VS$_R$ [NL/h pro Gramm Kohlenstoff im Reaktor] | 2,27 | 2,27 | 2,27 | 2,27 | 2,27 | 4,55 |
| **Abschnitt A:** Anteil am Sollgehalt im Produkt, [%Si] | - | - | 0,27 | 0,21 | 20 | 40 |
| **Abschnitt A:** Temperatur T$_A$, [°C] | - | - | 380 | 400 | 380 | 400 |
| **Abschnitt A:** Monosilan Konz. C$_A$, [Vol.-%] | - | - | 50 | 30 | 50 | 50 |
| **Abschnitt A:** Monosilan Volumenstrom VS$_A$ [NL/h pro Gramm Kohlenstoff im Reaktor] | - | - | 2,27 | 1,36 | 2,27 | 2,27 |
| $\Delta$**T,** [°C] | - | - | 20 | 0 | 30 | 0 |
| $\Delta$**C,** [Vol. -% ] | - | - | 0 | 20 | 0 | 50 |
| $\Delta$**VS,** [NL/h pro Gramm Kohlenstoff im Reaktor] | - | - | 0 | 0,90 | 0 | 0 |
| Gesamtumsatz, [%] | 56, 84 | 19, 42 | 53,55 | 44, 97 | 50,21 | 64,31 |
| Durchsatz [Gew.-%/h] | 82,76 | 28,74 | 49, 48 | 63, 16 | 45, 49 | 75, 68 |
| Menge Edukt, [g] | 2,20 | 2,20 | 2,20 | 2,20 | 2,20 | 2,20 |
| Menge Produkt, [g] | 4,29 | 4,22 | 4,22 | 4,11 | 4,18 | 4,28 |
| Si, [Gew.-%] | 48 | 48 | 48 | 48 | 48 | 48 |
| O, [Gew.-%] | 2,18 | 3,31 | 2,99 | 2,24 | 3,30 | 3,38 |
| grobes Si, [%] | 0, 6 | 0,0 | 0,0 | 0,0 | 0,0 | 0,0 |
| BET, [m$^2$/g] | 9,43 | 30,21 | 12, 4 | 11,44 | 26,11 | 17,40 |
| *nicht erfindungsgemäß | | | | | | |

In Abhängigkeit der gewählten Parameter M$_R$, M$_A$, T$_R$, T$_A$, C$_R$, C$_A$, VS$_A$, und VS$_R$ können der Gesamtumsatz des Si-Präkursors und der Durchsatz der Anlage unter gleichzeitiger Maximierung der Materialperformanz deutlich gesteigert werden.

**Evaluierung der Si-Kompositpartikel in elektrochemischen Zellen**

Beispiel 5: Die Si-Komposite aus den erfindungsgemäßen Beispielen 1-4 und aus den Vergleichsbeispielen wurden als Bestandteile von Anoden in LIB getestet.
29,71 g Polyacrylsäure (bei 85°C bis zur Gewichtskonstanz getrocknet; Sigma-Aldrich, Mw ~450.000 g/mol) und 756,60 g deionisiertes Wasser wurden mittels Schüttler (290 1/min) für 2,5 h bis zur vollständigen Lösung der Polyacrylsäure bewegt. Zu der Lösung wurde Lithiumhydroxid Monohydrat (Sigma-Aldrich) portionsweise hinzugegeben, bis der pH-Wert bei 7,0 lag (gemessen mit pH-Meter WTW pH 340i und Sonde SenTix RJD). Die Lösung wurde anschließend mittels Schüttler weitere 4 h durchmischt. 3,87 g der neutralisierten Polyacrylsäure-Lösung und 0,96 g Graphit (Imerys, KS6L C) wurden in einem 50 ml Gefäß vorgelegt und in einem Planetenmischer (SpeedMixer, DAC 150 SP) bei 2000 rpm vermengt. Anschließend wurden jeweils 3,35 g des Silicium-Komposits aus den Beispielen 1 bis 5 und Vergleichsbeispielen 1 und - bei 2000 rpm für 1 min untergerührt. Anschließend wurden 1,21 g einer 8 %-igen Leitrußdispersion und 0,8 g deionisiertes Wasser zugegeben und bei 2000 rpm am Planetenmischer eingearbeitet. Anschließend erfolgte die Dispergierung am Dissolver für 30 min bei 3000 rpm unter konstanten 20°C. Die Entgasung der Tinte erfolgte wieder im Planetenmischer bei 2500 rpm für 5 min unter Vakuum. Die fertige Dispersion wurde nun mittels eines Filmziehrahmens mit 0,06 mm Spalthöhe (Erichsen, Modell 360) auf eine Kupferfolie mit einer Dicke von 0,03 mm (Schlenk Metallfolien, SE-Cu58) aufgebracht. Die so hergestellte Anodenbeschichtung wurde anschließend 60 min bei 50°C und 1 bar Luftdruck getrocknet.

Das mittlere Flächengewicht der trockenen Anodenbeschichtung betrug 2,7 mg/cm$^2$ und die Beschichtungsdichte 0,8 g/cm$^3$.

Die elektrochemischen Untersuchungen wurden an einer Knopfzelle (Typ CR2032, Hohsen Corp.) in 2-Elektroden-Anordnung durchgeführt. Die Elektrodenbeschichtung wurde als Gegenelektrode bzw. negative Elektrode (Dm = 15 mm) eingesetzt. Eine Beschichtung auf Basis von Lithium-Nickel-Mangan-Kobaltoxid 6:2:2 mit Gehalt von 94,0% und mittlerem Flächengewicht von 15,9 mg/cm$^2$ (bezogen von der Firma SEI) wurde als Arbeitselektrode bzw. positive Elektrode (Dm = 15 mm) verwendet. Ein mit 60 $\mu$l Elektrolyt getränktes, Glasfaser-Filterpapier (Whatman, GD Type D) diente als Separator (Dm = 16 mm). Der verwendete Elektrolyt bestand aus einer 1,0-molaren Lösung von Lithiumhexafluorophosphat in einem 1:4 (v/v) Gemisch von Fluorethylencarbonat und Diethylcarbonat. Der Bau der Zelle erfolgte in einer Glovebox (< 1 ppm H$_2$O, O$_2$), der Wassergehalt in der Trockenmasse aller verwendeten Komponenten lag unterhalb von 20 ppm.

Die elektrochemische Testung wurde bei 20°C durchgeführt. Das Laden der Zelle erfolgte im cc/cv-Verfahren (constant current/constant voltage) mit konstantem Strom von 5 mA/g (entsprechend C/25) im ersten Zyklus und von 60 mA/g (entsprechend C/2) in den darauffolgenden Zyklen und nach Erreichen der Spannungsgrenze von 4,2 V mit konstanter Spannung bis Unterschreiten eines Stroms von 1,2 mA/g (entsprechend C/100) bzw. 15 mA/g (entsprechend C/8). Das Entladen der Zelle erfolgte im cc-Verfahren (constant current) mit konstantem Strom von 5 mA/g (entsprechend C/25) im ersten Zyklus und von 60 mA/g (entsprechend C/2) in den darauffolgenden Zyklen bis Erreichen der Spannungsgrenze von 2,5 V. Der gewählte spezifische Strom bezog sich auf das Gewicht der Beschichtung der positiven Elektrode. Die Elektroden wurden so gewählt, dass ein Kapazitätsverhältnis von Kathode zu Anode von 1:1,2 eingestellt wurde.

Die Ergebnisse der elektrochemischen Testung der Vollzellen von LIB enthaltend Si-Komposite aus den Beispielen 1 bis 4 und den Vergleichsbeispielen 1 und 2 sind in Tabelle 4 aufgeführt.

Tabelle 4

| #Beispiel | Reversible spezifische Kapazität der negativen Elektrode im zweiten Zyklus, [mAh/g] | Zyklenzahl mit ≥ 80% Kapazitätserhalt | Coulomb-effizienz Formierung [%] |
|---|---|---|---|
| Vbsp 1* | 1034 | 391 | 86,5 |
| Vbsp 2* | 1064 | 842 | 85,6 |
| Bsp 1 | 1086 | 833 | 85,3 |
| Bsp 2 | 1066 | 870 | 86,7 |
| Bsp 3 | 1063 | 862 | 85,7 |
| Bsp 4 | 1039 | 687 | 85,8 |

*nicht erfindungsgemäß

Das Vergleichsbeispiel 1 offenbart einen hohen Durchsatz bei gutem Umsatz des Si-Präkursors, liefert jedoch einen Gehalt an grobem Si von 0,6% (Tabelle 3) und erreicht somit nur noch eine niedrige Zyklenstabilität. Das Vergleichsbeispiel 2 offenbart eine gute elektrochemische Performanz, welche jedoch nur über einen geringen Umsatz und Durchsatz erreicht werden konnte (Tabelle 4).

Die erfindungsgemäßen Beispiele 1-3 zeigen im Vergleich zum Vergleichsbeispiel 2 einen höheren Durchsatz und höheren Umsatz unter Aufrechterhaltung einer sehr guten elektrochemischen Performanz. Im Gegensatz zum Vergleichsbeispiel 1 liefern die Beispiele 1-3 kein grobes Si und sind somit als vorteilhaft zu betrachten. Das Beispiel 4 erreicht durch die Anpassung der Temperatur und der Silankonzentration eine bessere elektrochemische Performanz als Vergleichsbeispiel 1 bei gleichzeitig höherem Umsatz.

**Patentansprüche**

1. Verfahren zur Herstellung eines Silicium-Komposits durch thermische Zersetzung von zumindest einem Si-Präkursor in Anwesenheit von porösen Partikeln, wobei Silicium in Poren und auf der Oberfläche der porösen Partikel abgeschieden wird und das Silicium-Komposit einen Soll-Gehalt an Si von 35 bis 60 Gew.-% aufweist, wobei das Verfahren im Regelbetrieb durchgeführt wird bei

   - einer mittleren Temperatur $T$ von 300 bis 500°C und
   - einer Konzentration $C$ des Silicium-Präkursors von 30 bis 100 Vol.-% und
   **dadurch gekennzeichnet, dass** das Verfahren mindestens einen Abschnitt A umfasst, in welchem bei zumindest einem der Parameter $T$ und $C$ gegenüber dem Regelbetrieb und gegebenenfalls gegenüber einem weiteren Abschnitt A eine Änderung $\Delta$ erfolgt, wobei

$$\Delta T = 10 \text{ bis } 130°C,$$

$$\Delta C = 2 \text{ bis } 70 \text{ Vol.-}\%,$$

   mit der Maßgabe, dass während des Abschnitts A 0,1 bis 50 % des genannten Soll-Gehalts abgeschieden werden oder dass während zwei oder mehreren Abschnitten A insgesamt maximal 50 % des genannten Soll-Gehalts abgeschieden werden.

2. Verfahren zur Herstellung eines Silicium-Komposits durch thermische Zersetzung von zumindest einem Silicium-Präkursor in Anwesenheit von porösen Partikeln, wobei Silicium in Poren und auf der Oberfläche der porösen Partikel abgeschieden wird und das Silicium-Komposit einen Soll-Gehalt an Si von 35 bis 60 Gew.-% aufweist, wobei das Verfahren im Regelbetrieb durchgeführt wird bei

   - einer mittleren Temperatur $T$ von 300 bis 500°C,
   - einer Konzentration $C$ des Silicium-Präkursors von 30 bis 100 Vol.-% und
   - einem Volumenstrom $VS$ des Silicium-Präkursors von 0,01 bis 20 NL/h, bezogen auf 1 g der porösen Partikel und
   **dadurch gekennzeichnet, dass** das Verfahren mindestens einen Abschnitt A umfasst, in welchem bei zumindest einem der Parameter $T$, $C$ und $VS$ gegenüber dem Regelbetrieb und/oder gegenüber einem weiteren Abschnitt A eine Änderung $\Delta$ erfolgt, wobei

$$\Delta T = 10 \text{ bis } 130°C,$$

$$\Delta C = 2 \text{ bis } 70 \text{ Vol.-}\%,$$

$$\Delta VS = 0,01 \text{ bis } 10 \text{ NL/h},$$

   mit der Maßgabe, dass während des Abschnitts A 0,1 bis 50 % des genannten Soll-Gehalts abgeschieden werden oder dass während zwei oder mehreren Abschnitten A insgesamt maximal 50 % des genannten Soll-Gehalts abgeschieden werden.

3. Verfahren nach Anspruch 2, **dadurch gekennzeichnet, dass** VS im Regelbetrieb 0,01 bis 10 NL/h, besonders bevorzugt 0,01 bis 5 NL/h bezogen auf 1 g der porösen Partikel, beträgt.

4. Verfahren nach Anspruch 2 oder 3, **dadurch gekennzeichnet, dass** ⊿VS 0,01 bis 5 NL/h, bevorzugt 0,01 bis 2 NL/h bezogen auf 1 g der porösen Partikel, beträgt.

5. Verfahren nach einem der vorhergehenden Ansprüche, **dadurch gekennzeichnet, dass** das Silicium-Komposit einen Soll-Gehalt an Si von 40 bis 55 Gew.-%, bevorzugt von 42 bis 50 Gew.-%, aufweist.

6. Verfahren nach einem der vorhergehenden Ansprüche, **dadurch gekennzeichnet, dass** der Soll-Gehalt an Si während des Verfahrens durch Analyse der Zusammensetzung eines Abgasstroms mit mindestens einer Methode erfolgt, ausgewählt aus der Gruppe mit Gaschromatographie, Massenspektrometrie, Infrarotspektroskopie und Wärmeleitfähigkeitsmessung.

7. Verfahren nach einem der vorhergehenden Ansprüche, **dadurch gekennzeichnet, dass** T im Regelbetrieb 315°C bis 475°C, bevorzugt 330 bis 450°C, beträgt.

8. Verfahren nach einem der vorhergehenden Ansprüche, **dadurch gekennzeichnet, dass** C im Regelbetrieb 40 bis 100 Vol.-%, bevorzugt 50 bis 100 Vol.-%, beträgt.

9. Verfahren nach einem der vorhergehenden Ansprüche, **dadurch gekennzeichnet, dass** ⊿T 20 bis 100°C, bevorzugt 20 bis 50°C, beträgt.

10. Verfahren nach einem der vorhergehenden Ansprüche, **dadurch gekennzeichnet, dass** ⊿C 5 bis 60 Vol.-%, bevorzugt 10 bis 50 Vol.-%, beträgt.

11. Verfahren nach einem der vorhergehenden Ansprüche, **dadurch gekennzeichnet, dass** die Änderung ⊿ von Beginn des Abschnitts A bis zu dessen Ende kontinuierlich erfolgt.

12. Verfahren nach einem der vorhergehenden Ansprüche, **dadurch gekennzeichnet, dass** das Verfahren bei einem Druck von weniger als 0,7 MPa durchgeführt wird.

13. Verfahren nach einem der vorhergehenden Ansprüche, durchgeführt in einem Reaktor, der mit einem wandgängigen Rührer ausgestattet ist.

14. Verfahren nach einem der vorhergehenden Ansprüche, durchgeführt in einem Kaskadenreaktorsystem, umfassend mehrere Reaktoren

15. Verfahren nach einem der vorhergehenden Ansprüche, **dadurch gekennzeichnet, dass** der Silicium-Präkursor ausgewählt ist aus der Gruppe mit Monosilan, Disilan, Trichlorsilan, Dichlorsilan, Methylsilan und Mischungen davon.

16. Verfahren nach einem der vorhergehenden Ansprüche, **dadurch gekennzeichnet, dass** es sich bei den porösen Partikeln um amorphen Kohlenstoff handelt, ausgewählt aus der Gruppe mit Hardcarbon, Softcarbon, Mesocarbon, Microbeads, Naturgraphit oder synthetischen Graphit, ein- und mehrwandige Kohlenstoffnanoröhren, Graphen und Mischungen davon.

**Claims**

1. Process for producing a silicon composite by thermal decomposition of at least one Si precursor in the presence of porous particles, wherein silicon is deposited in pores and on the surface of the porous particles and the silicon composite has a target content of Si of 35% to 60% by weight, wherein in regular operation the process is performed at

    - an average temperature T of 300°C to 500°C and
    - a concentration C of the silicon precursor of 30% to 100% by volume and
    **characterized in that** the process comprises at least one stage A in which a change ⊿ in at least one of the parameters *T* and *C* relative to regular operation and optionally relative to a further stage A is effected, wherein

$$\Delta T = 10°C \text{ to } 130°C,$$

$$\Delta C = 2\% \text{ to } 70\% \text{ by volume},$$

with the proviso that during stage A 0.1% to 50% of the recited target content is deposited or that during two or more stages A altogether at most 50% of the recited target content is deposited.

2. Process for producing a silicon composite by thermal decomposition of at least one silicon precursor in the presence of porous particles, wherein silicon is deposited in pores and on the surface of the porous particles and the silicon composite has a target content of Si of 35% to 60% by weight, wherein in regular operation the process is performed at

- an average temperature *T* of 300°C to 500°C,
- a concentration *C* of the silicon precursor of 30% to 100% by volume and
- a volume flow *VS* of the silicon precursor of 0.01 to 20 NL/h, based on 1 g of the porous particles, and
**characterized in that** the process comprises at least one stage A in which a change *Δ* in at least one of the parameters *T,* C and *VS* relative to regular operation and/or relative to a further stage A is effected, wherein

$$\Delta T = 10°C \text{ to } 130°C,$$

$$\Delta C = 2\% \text{ to } 70\% \text{ by volume},$$

$$\Delta VS = 0.01 \text{ to } 10 \text{ NL/h},$$

with the proviso that during stage A 0.1% to 50% of the recited target content is deposited or that during two or more stages A altogether at most 50% of the recited target content is deposited.

3. Process according to Claim 2, **characterized in that** in regular operation VS is 0.01 to 10 NL/h, particularly preferably 0.01 to 5 NL/h, based on 1 g of the porous particles.

4. Process according to Claim 2 or 3, **characterized in that** *ΔVS* is 0.01 to 5 NL/h, preferably 0.01 to 2 NL/h, based on 1 g of the porous particles.

5. Process according to any of the preceding claims, **characterized in that** the silicon composite has a target content of Si of 40% to 55% by weight, preferably of 42% to 50% by weight.

6. Process according to any of the preceding claims, **characterized in that** the target content of Si is determined during the process by analysis of the composition of an offgas stream with at least one method selected from the group comprising gas chromatography, mass spectrometry, infrared spectroscopy and thermal conductivity measurement.

7. Process according to any of the preceding claims, **characterized in that** in regular operation T is 315°C to 475°C, preferably 330°C to 450°C.

8. Process according to any of the preceding claims, **characterized in that** in regular operation *C* is 40% to 100% by volume, preferably 50% to 100% by volume.

9. Process according to any of the preceding claims, **characterized in that** *ΔT* is 20°C to 100°C, preferably 20°C to 50°C.

10. Process according to any of the preceding claims, **characterized in that** *ΔC* is 5% to 60% by volume, preferably 10% to 50% by volume.

**11.** Process according to any of the preceding claims, **characterized in that** the change $\Delta$ is carried out continuously from commencement of stage A until termination thereof.

**12.** Process according to any of the preceding claims, **characterized in that** the process is performed at a pressure of less than 0.7 MPa.

**13.** Process according to any of the preceding claims, performed in a reactor fitted with a close-clearance stirrer.

**14.** Process according to any of the preceding claims, performed in a cascade reactor system comprising two or more reactors.

**15.** Process according to any of the preceding claims, **characterized in that** the silicon precursor is selected from the group comprising monosilane, disilane, trichlorosilane, dichlorosilane, methylsilane and mixtures thereof.

**16.** Process according to any of the preceding claims, **characterized in that** the porous particles are amorphous carbon selected from the group comprising hard carbon, soft carbon, mesocarbon, microbeads, natural graphite or synthetic graphite, single- and multi-walled carbon nanotubes, graphene and mixtures thereof.

**Revendications**

**1.** Procédé de fabrication d'un composite de silicium par décomposition thermique d'au moins un précurseur de Si en présence de particules poreuses, le silicium étant déposé dans des pores et sur la surface des particules poreuses, et le composite de silicium présentant une teneur de consigne en Si de 35 à 60 % en poids, le procédé étant, en marche normale, mis en oeuvre

- à une température moyenne T de 300 à 500 °C et
- pour une concentration C du précurseur de silicium de 30 à 100 % en volume, et
**caractérisé en ce que** le procédé comprend au moins une partie A dans laquelle, pour au moins l'un des paramètres T et C, il se produit par rapport à la marche normale et éventuellement par rapport à une autre partie A une variation $\Delta$, avec

$$\Delta T = 10 \ \text{à} \ 130 \ °C,$$

$$\Delta C = 2 \ \text{à} \ 70 \ \% \ \text{en volume,}$$

à la condition que, pendant la partie A, il y ait dépôt de 0,1 à 50 % de la teneur de consigne mentionnée, ou **en ce qu'**il y ait, pendant deux ou plusieurs parties A, dépôt total au maximum de 50 % de la teneur de consigne mentionnée.

**2.** Procédé de fabrication d'un composite de silicium par décomposition thermique d'au moins un précurseur de silicium en présence de particules poreuses, le silicium étant déposé dans les pores et sur la surface des particules poreuses, et le composite de silicium présentant une teneur de consigne en Si de 35 à 60 % en poids, le procédé étant mis en oeuvre en marche normale

- à une température moyenne T de 300 à 500 °C,
- pour une concentration C du précurseur de silicium de 30 à 100 % en volume et
- pour un débit volumique *VS* du précurseur de silicium de 0,01 à 20 NL/h, par gramme des particules poreuses, et **caractérisé en ce que** le procédé comprend au moins une partie A dans laquelle, pour au moins l'un des paramètres *T, C* et *VS,* il se produit par rapport à la marche normale et/ou par rapport à une autre partie A une variation $\Delta$, avec

$$\Delta T = 10 \ \text{à} \ 130 \ °C,$$

$$\Delta C = 2 \text{ à } 70 \text{ \% en volume,}$$

$$\Delta VS = 0,01 \text{ à } 10 \text{ NL/h,}$$

à la condition que, pendant la partie A, il y ait dépôt de 0,1 à 50 % de la teneur de consigne mentionnée, ou **en ce que**, pendant deux ou plusieurs parties A, il y ait dépôt en tout au maximum de 50 % de la teneur de consigne mentionnée.

3. Procédé selon la revendication 2, **caractérisé en ce que** le $VS$, en marche normale, est de 0,01 à 10 NL/h, d'une manière particulièrement préférée de 0,01 à 5 NL/h par gramme des particules poreuses.

4. Procédé selon la revendication 2 ou 3, **caractérisé en ce que** le $\Delta VS$ est de 0,01 à 5 NL/h, de préférence de 0,01 à 2 NL/h par gramme des particules poreuses.

5. Procédé selon l'une des revendications précédentes, **caractérisé en ce que** le composite de silicium présente une teneur de consigne en Si de 40 à 55 % en poids, de préférence de 42 à 50 % en poids.

6. Procédé selon l'une des revendications précédentes, **caractérisé en ce que** la teneur de consigne en Si pendant le procédé est réalisée par analyse de la composition d'un courant de gaz résiduaire, par au moins une méthode choisie dans le groupe chromatographie en phase gazeuse, spectrométrie de masse, spectroscopie infrarouge et mesure de la conductivité thermique.

7. Procédé selon l'une des revendications précédentes, **caractérisé en ce que** $T$ en marche normale est de 315 °C à 475 °C, de préférence de 330 à 450 °C.

8. Procédé selon l'une des revendications précédentes, **caractérisé en ce que** $C$ en marche normale est de 40 à 100 % en volume, de préférence de 50 à 100 % en volume.

9. Procédé selon l'une des revendications précédentes, **caractérisé en ce que** $\Delta T$ est de 20 à 100 °C, de préférence de 20 à 50 °C.

10. Procédé selon l'une des revendications précédentes, **caractérisé en ce que** $\Delta C$ est de 5 à 60 % en volume, de préférence de 10 à 50 % en volume.

11. Procédé selon l'une des revendications précédentes, **caractérisé en ce que** la variation $\Delta$ se produit en continu du début à la fin de la partie A.

12. Procédé selon l'une des revendications précédentes, **caractérisé en ce que** le procédé est mis en oeuvre sous une pression inférieure à 0,7 MPa.

13. Procédé selon l'une des revendications précédentes, mis en oeuvre dans un réacteur qui est équipé d'un agitateur-racleur.

14. Procédé selon l'une des revendications précédentes, mis en oeuvre dans un système de réacteurs en cascade, comprenant plusieurs réacteurs.

15. Procédé selon l'une des revendications précédentes, **caractérisé en ce que** le précurseur de silicium est choisi dans le groupe monosilane, disilane, trichlorosilane, dichlorosilane, méthylsilane et les mélanges de ceux-ci.

16. Procédé selon l'une des revendications précédentes, **caractérisé en ce que** les particules poreuses sont constituées de carbone amorphe, choisi dans le groupe carbone dur, carbone souple, mésocarbone, micro-perles, graphite naturel ou graphite synthétique, nanotubes de carbone mono- et multiparois, graphène et les mélanges de ceux-ci.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1730800 B1
- EP 3335262 B1
- WO 2022029422 A1
- GB 2580110 B
- US 10964940 B1
- CN 105185970 A